# EUROPEAN PATENT APPLICATION

(11) **EP 4 723 824 A1**
(43) Date of publication of application: **08.04.2026**
(21) Application number: 25195537.3
(22) Date of filing: 12.08.2025
(51) Int. Cl.: H10B 43/50, H10B 43/10, H10B 43/27

(54) **SEMICONDUCTOR DEVICES AND DATA STORAGE SYSTEMS INCLUDING THE SAME**

(30) Priority: 04.10.2024 KR 20240134940
(71) Applicant: Samsung Electronics Co., Ltd., Suwon-si, Gyeonggi-do 16677 (KR)
(72) Inventor: JEON, Wooyong, 16677 Suwon-si (KR); GO, Sujin, 16677 Suwon-si (KR); KIM, Hyunji, 16677 Suwon-si (KR); SUNG, Jeongyong, 16677 Suwon-si (KR); OH, Dongsik, 16677 Suwon-si (KR); LEE, Sungchul, 16677 Suwon-si (KR); JO, Woongrae, 16677 Suwon-si (KR)
(74) Representative: Marks & Clerk LLP

(57) **Abstract**

A semiconductor device includes a stack structure comprising gate electrodes, wherein the stack structure includes a first region, a second region, and a third region therebetween; an insulating layer on the stack structure; a channel structure extending into the stack structure in the first region; first contact plugs extending into the insulating layer, wherein the first contact plugs are electrically connected to the pad regions of the ones of the upper gate electrodes, respectively, in the third region; second contact plugs extending into at least one among the gate electrodes and the insulating layer, wherein ones of the second contact plugs extend to different lengths in the second region; a side-surface insulating structure extending around a side surface of each of the second contact plugs; and an upper side-surface insulating layer extending around a side surface of each of the first contact plugs.

## Description

### BACKGROUND OF THE INVENTION

Example embodiments of the present disclosure may relate to semiconductor devices and data storage systems including the same.

Semiconductor devices able to store high-capacity data in a data storage system requiring data storage has been needed. Accordingly, methods for increasing data storage capacity of a semiconductor device have been researched. For example, as a method for increasing data storage capacity of a semiconductor device, a semiconductor device including memory cells disposed three-dimensionally, instead of memory cells disposed two-dimensionally, has been suggested.

### SUMMARY OF THE INVENTION

An example embodiment of the present disclosure may provide a semiconductor device formed by a simplified manufacturing process.

An example embodiment of the present disclosure may provide a data storage system including a semiconductor device formed by a simplified manufacturing process.

According to an example embodiment of the present disclosure, a semiconductor device includes a conductive layer; a stack structure on the conductive layer, wherein the stack structure includes a first region, a second region, and a third region that is between the first region and the second region in a first direction that is parallel with an upper surface of the conductive layer, wherein the stack structure further includes lower gate electrodes, memory gate electrodes, and upper gate electrodes, that are stacked and spaced apart from each other in a second direction that is perpendicular to the upper surface of the conductive layer, and wherein ones of the upper gate electrodes extend to different lengths from one another in the first direction in the third region and the ones of the upper gate electrodes include pad regions, respectively; an insulating layer on the stack structure; a channel structure that extends into the stack structure in the second direction in the first region; first contact plugs that extend into the insulating layer in the second direction, wherein the first contact plugs are electrically connected to the pad regions of the ones of the upper gate electrodes, respectively, in the third region; second contact plugs that extend into at least one among the upper gate electrodes, the memory gate electrodes, and the lower gate electrodes and into the insulating layer in the second direction, wherein ones of the second contact plugs extend to different lengths from one another in the second direction and are electrically connected to the lower gate electrodes and/or the memory gate electrodes, respectively, in the second region; a side-surface insulating structure that extends around a side surface of each of the second contact plugs in the second region; and an upper side-surface insulating layer that extends around a side surface of each of the first contact plugs in the third region.

According to an example embodiment of the present disclosure, a semiconductor device includes a conductive layer; a stack structure on the conductive layer, wherein the stack structure includes a first region, a second region, and a third region that is between the first region and the second region in a first direction that is parallel with an upper surface of the conductive layer, wherein the stack structure includes memory gate electrodes and upper gate electrodes that are stacked and spaced apart from each other in a second direction that is perpendicular to the upper surface of the conductive layer, and wherein ones of the upper gate electrodes extend to different lengths in the first direction in the third region and the ones of the upper gate electrodes include pad regions, respectively; an insulating layer on the stack structure; isolation regions that extend into the upper gate electrodes in the first direction in the first region and the third region; a channel structure that extends into the stack structure in the second direction in the first region; first contact structures that extend into the insulating layer in the second direction, wherein the first contact structures are electrically connected to the pad regions of the ones of the upper gate electrodes, respectively, in the third region; second contact structures that extend into the upper gate electrodes, the insulating layer, and at least one of the memory gate electrodes, wherein the second contact structures are electrically connected to the memory gate electrodes, respectively, in the second region, and wherein respective upper surfaces of the second contact structures are coplanar with respective upper surfaces of the first contact structures; first studs on the first contact structures; and second studs on the second contact structures, wherein respective upper surfaces of the first studs are coplanar with respective upper surfaces of the second studs, and wherein respective lower surfaces of the first studs are coplanar with respective lower surfaces of the second studs.

According to an example embodiment of the present disclosure, a data storage system includes a semiconductor storage device that includes a first semiconductor structure that includes circuit devices, a second semiconductor structure on the first semiconductor structure, and an input/output pad that is electrically connected to the circuit devices; and a controller that is electrically connected to the semiconductor storage device through the input/output pad, wherein the controller is configured to control the semiconductor storage device, wherein the second semiconductor structure comprises: a conductive layer; a stack structure on the conductive layer, wherein the stack structure includes a first region, a second region, and a third region that is between the first region and the second region in a first direction that is parallel with an upper surface of the conductive layer, wherein the stack structure includes lower gate electrodes, memory gate electrodes, and upper gate electrodes that are stacked and spaced apart from each other in a second direction that is perpendicular to the upper surface of the conductive layer, and wherein ones of the upper gate electrodes extend to different lengths from one another in the first direction in the third region and include pad regions; an insulating layer on the stack structure; a channel structure that extends into the stack structure in the second direction in the first region; first contact plugs that extend into the insulating layer in the second direction, wherein the first contact plugs are electrically connected to the pad regions of the upper gate electrodes, respectively, in the third region; second contact plugs that extend into at least one among the upper gate electrodes, the memory gate electrodes, and the lower gate electrodes and the insulating layer in the second direction, wherein ones of the second contact plugs extend to different lengths from one another in the second direction and are electrically connected to the lower gate electrodes and/or the memory gate electrodes, respectively, in the second region; a side-surface insulating structure that extends around a side surface of each of the second contact plugs in the second region; and an upper side-surface insulating layer that extends around a side surface of each of the first contact plugs in the third region.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan view illustrating a semiconductor device according to example embodiments of the present disclosure;
FIGS. 2A and 2B are cross-sectional views illustrating a semiconductor device according to example embodiments of the present disclosure;
FIGS. 3A, 3B, and 3C are enlarged views illustrating a partial region in FIG. 2A;
FIGS. 4 to 7 are enlarged cross-sectional views illustrating a semiconductor device according to example embodiments of the present disclosure;
FIGS. 8 to 10 are cross-sectional views illustrating a semiconductor device according to example embodiments of the present disclosure;
FIGS. 11A, 11B, 11C, 11D, 11E, 11F, 11G, 11H, 11I, 11J, and 11K are cross-sectional views illustrating a method of manufacturing a semiconductor device according to example embodiments of the present disclosure;
FIG. 12 is a view illustrating a data storage system including a semiconductor device according to example embodiments of the present disclosure; and
FIG. 13 is a perspective view illustrating a data storage system including a semiconductor device according to an example embodiment of the present disclosure.

### DETAILED DESCRIPTION

Hereinafter, embodiments of the present disclosure will be described as follows with reference to the accompanying drawings.

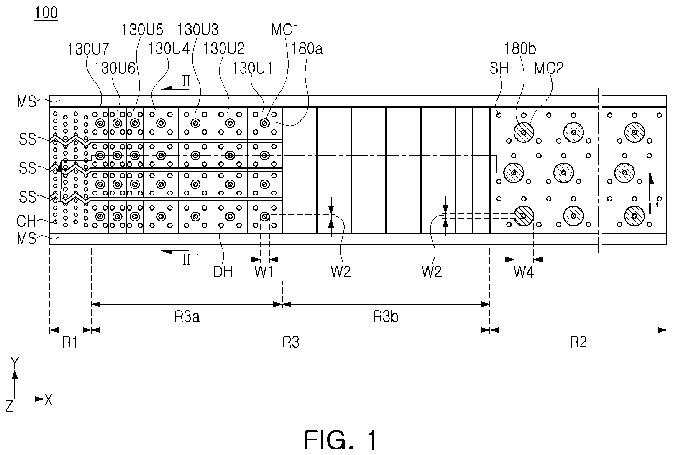

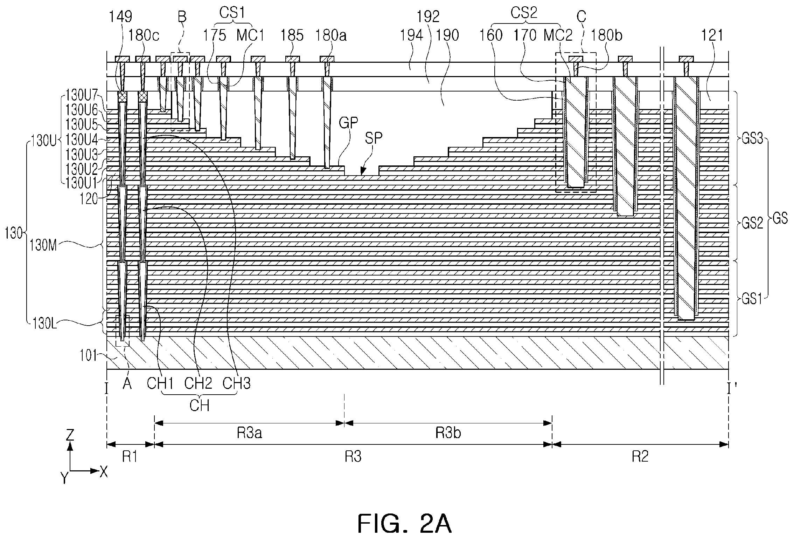

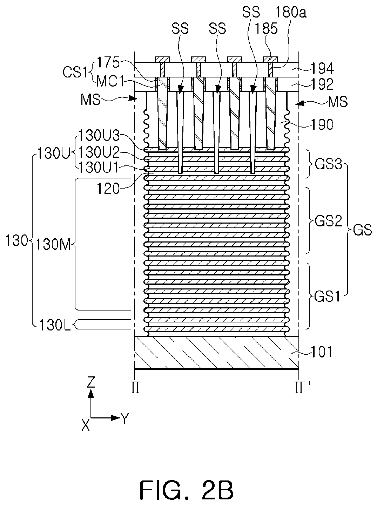

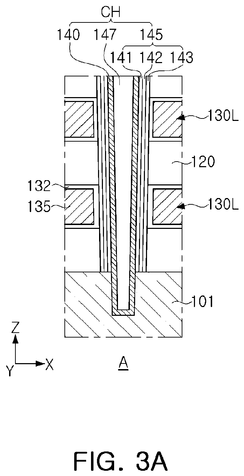

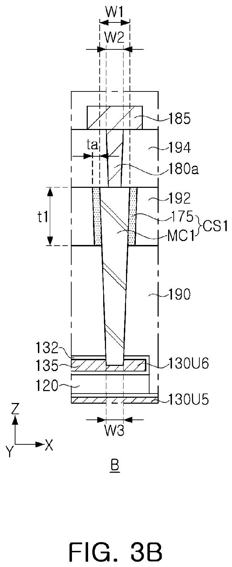

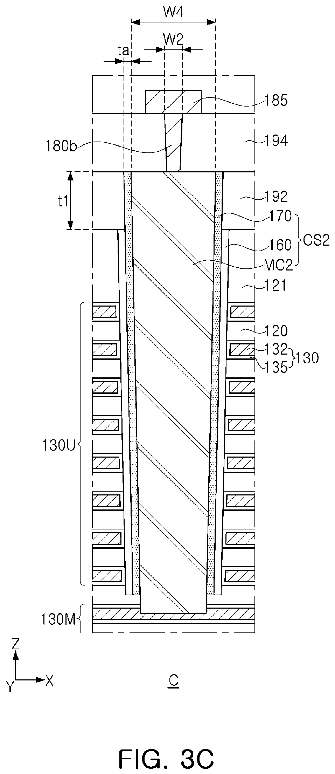

FIG. 1 is a plan view illustrating a semiconductor device according to example embodiments. FIGS. 2A and 2B are cross-sectional views illustrating a semiconductor device according to example embodiments. FIG. 2A is a cross-sectional view illustrating a region of the semiconductor device in FIG. 1 taken along line I-I', and FIG. 2B is a cross-sectional view illustrating a region of the semiconductor device in FIG. 1 taken along line II-II'. FIG. 3A is an enlarged view illustrating region 'A' in FIG. 2A, FIG. 3B is an enlarged view illustrating region 'B' in FIG. 2A, and FIG. 3C is an enlarged view illustrating region 'C' in FIG. 2A.

Referring to FIGS. 1, 2A, 2B, 3A, 3B, and 3C, a semiconductor device 100 may include a memory region R1 and an extension region R2 at one side of the memory region R1 in a first horizontal direction (e.g., the X-direction). The term "horizontal" may refer to a direction that runs parallel to an upper surface of a conductive layer 101 of the semiconductor device 100. Similarly, the term "vertical" may refer to a direction that runs perpendicular to the upper surface of the conductive layer 101. These terms are defined relative to the structure of the semiconductor device 100 and need not imply any particular orientation of the semiconductor device 100 in use.

The memory region R1 may be configured as a memory cell region in which memory cell strings CSTR are disposed, and channel structures CH may be disposed in the memory region R1. The extension region R2 may be a region for electrically connecting the channel structures CH to peripheral circuit structures, and to this end, a plurality of wordline contact plugs MC2 (electrically) connected to gate electrodes at different levels may be disposed in the extension region R2, but an example embodiment thereof is not limited thereto.

An upper contact region R3 may be disposed between the memory region R1 and the extension region R2 (in the first horizontal direction). The upper contact region R3 may be a region in which the upper contact plugs MC1 (electrically) connected to the upper gate electrodes 130U are disposed. For example, the upper contact plugs MC1 (electrically) connected to the erase gate electrodes (e.g., the erase gate electrodes 130U5, 130U6, and 130U7) and the string select gate electrodes (e.g., the string select gate electrodes 130U1, 130U2, 130U3, and 130U4) may be disposed in the upper contact region R3.

More specifically, the upper contact region R3 may be defined as including a first upper contact region R3a adjacent to the memory region R1, in which the upper contact plugs MC1 (electrically) connected to the erase gate electrodes 130U5, 130U6, and 130U7 and the string select gate electrodes 130U1, 130U2, 130U3, and 130U4 are disposed, and a second upper contact region R3b between the first upper contact region R3a and the extension region R2 (in the first horizontal direction) in which the upper contact plugs MC1 are not disposed and the upper gate electrodes 130U form a staircase shape.

In the first upper contact region R3a, the upper gate electrodes 130U (electrically) connected to the upper contact plugs MC1, respectively, may form a step difference structure having a staircase shape in which the number of steps (e.g. the level of the uppermost upper gate electrode 130U) decreases in the first horizontal direction (e.g., the X-direction) toward the extension region R2, and the regions of the exposed upper gate electrode 130U may form pad regions GP, and may be in contact with the upper contact plugs MC1 in the pad regions GP, respectively. The second upper contact region R3b may be connected to the extension region R2, and may form a staircase shape symmetrically (in the first horizontal direction) with the first upper contact region R3a, and may form a step difference structure having a staircase shape in which the number of steps (e.g. the level of the uppermost upper gate electrode 130U) increases in the first horizontal direction (e.g. the X-direction) toward the extension region R2. Accordingly, the upper contact region R3 may also be defined as a region etched such that the upper gate electrodes 130U may form a staircase shape.

The semiconductor device 100 may have a structure in which the memory region R1, the upper contact region R3, and the extension region R2 are disposed in order in in the first horizontal direction (e.g., the X-direction).

The semiconductor device 100 may include a conductive layer 101, stack structures GS (GS1-GSk, where k is a positive integer) in which gate electrodes 130 and interlayer insulating layers 120 are alternately stacked on an upper surface of conductive layer 101 in a memory region R1, an upper contact region R3, and the extension region R2, channel structures CH disposed in the memory region R1 to extend into (e.g., penetrate) the stack structures GS1-GSk, isolation regions MS extending into (e.g., penetrating) the stack structures GS1-GSk and extending in the first horizontal direction (e.g., the X-direction), and insulating regions SS extending into (e.g., penetrating) at least a portion of the gate electrodes 130. An interconnection structure and a passivation layer may be further included below the conductive layer 101.

In the extension region R2, support structures SH and wordline contact plugs MC2 may be disposed, and in the upper contact region R3, dummy channel structures DH and upper contact plugs MC1 may be disposed.

In FIGS. 2A, 2B, 3A, 3B, and 3C, the contact plugs MC1 and MC2 (the upper contact plugs MC1 and the wordline contact plugs MC2) are illustrated as extending to different lengths for (electrical) connection between each gate electrode 130 and the contact plugs MC1 and MC2, but an example embodiment thereof is not limited thereto.

The memory region R1 and the extension region R2 may include a cell region insulating layer 190 as an upper portion of the stack structure GS. For example, the cell region insulating layer 190 may be on the stack structure GS. A first upper insulating layer 192 may be on the cell region insulating layer 190, and a second upper insulating layer 194 may be on the first upper insulating layer 192. The first upper insulating layer 192 may be between the cell region insulating layer 190 and the second upper insulating layer 194. The contact plugs MC1 and MC2 may extend into (e.g., penetrate) the cell region insulating layer 190 and/or the first upper insulating layer 192, but the embodiments are not limited thereto. The memory region R1, the extension region R2, and the upper contact region R3 may include first, second, and third studs 180a, 180b, and 180c for electrical connection with the channel structure CH and the contact plugs MC1 and MC2. For example, the memory region R1, the extension region R2, and the upper contact region R3 may include the third studs 180c, the first studs 180a, and the second studs 180b, respectively, but the embodiments are not limited thereto. The first, second, and third studs 180a, 180b, and 180c may extend into (e.g., penetrate) the second upper insulating layer 194, but the embodiments are not limited thereto. In some embodiments, the first, second, and third studs 180a, 180b, and 180c may be in contact with the contact plugs MC1 and MC2. The memory region R1, the extension region R2, and the upper contact region R3 may include one or more cell interconnection lines 185 on the second upper insulating layer 194. The cell interconnection line(s) 185 may be (electrically) connected to the first, second, and third studs 180a, 180b, and 180c.

The conductive layer 101 may include a conductive material such as doped silicon, a metal, and/or a metal nitride as a common source (a common source line). For example, the conductive layer 101 may include a silicon layer having N-type conductivity which may be a common source.

The gate electrodes 130 may be vertically spaced apart from each other on the upper surface of the conductive layer 101 and may form the stack structure GS (GS1-GS3) together with the interlayer insulating layers 120.

For the entire stack structures GS, the gate electrodes 130 may include at least one lower gate electrode 130L forming a gate of a ground select transistor, memory gate electrodes 130M forming gates of a plurality of memory cells, and upper gate electrodes 130U as string select gate electrodes forming gates of string select transistors. Here, the lower gate electrode 130L and the upper gate electrodes 130U may be referred to as the "lower portion" and the "upper portion" with respect to the direction during the manufacturing process. The number of memory gate electrodes 130M forming the gates of the memory cells may be determined depending on capacity of the semiconductor device 100. According to an example embodiment, the number of each of the upper and lower gate electrodes 130U and 130L may be 1 to 2 or more, and they may have a structure the same as or different from a structure of the memory gate electrodes 130M. In the example embodiment, the number of the upper gate electrodes 130U is illustrated as seven. Erase gate electrodes 130U5, 130U6, and 130U7 may be disposed on the string select gate electrodes 130U1, 130U2, 130U3, and 130U4 and may be included in the upper gate electrodes 130U. Accordingly, the seven upper gate electrodes 130U may be understood as having three erase gate electrodes 130U7, 130U6, and 130U5 and four string select gate electrodes 130U4, 130U3, 130U2, and 130U1 disposed in order downwardly. Also, a portion of the gate electrodes 130, for example, the memory gate electrodes 130M adjacent to the upper or lower gate electrode 130U or 130L, may be dummy gate electrodes 130, but an example embodiment thereof is not limited thereto.

The gate electrodes 130 may extend from the extension region R2 to the memory region R1 on one side. For example, the gate electrodes 130 may extend in the first horizontal direction (e.g., the X-direction) between the extension region R2 and one side of the memory region R1. The upper gate electrodes 130U may be upper ones (may be in an upper portion) of the gate electrodes 130. The upper gate electrodes 130U in an upper portion (of the gate electrodes 130) may be etched in order from the first upper contact region R3a and may form a staircase shape exposing the pad region GP of the upper gate electrode 130U. Also, in the second upper contact region R3b, the upper gate electrodes 130U may be etched in order to expose the pad region GP of the upper gate electrodes 130U. In this case, the staircase directions of the first and second upper contact regions R3a and R3b may be formed symmetrically to each other (in the horizontal direction (e.g., the X-direction)), but an example embodiment thereof is not limited thereto. When the upper gate electrodes 130U include seven gate electrodes 130 from an upper portion of the gate electrodes 130, a buffer region SP in which the eighth gate electrode 130 (e.g. the gate electrode 130 immediately below the first upper gate electrode 130U1; the upper-most memory gate electrode 130M) is partially exposed may be further formed, but an example embodiment thereof is not limited thereto. The staircase shape of the first upper contact region R3a and the staircase shape of the second upper contact region R3b may be formed to face each other with the buffer region SP as a center portion in the first horizontal direction (e.g., the X-direction). By this staircase shape, the upper gate electrodes 130U of the first upper contact region R3a and the second upper contact region R3b may be physically and electrically isolated from each other. For example, (portions of) the upper gate electrodes 130U in the first upper contact region R3a and (portions of) the upper gate electrodes 130U in the second upper contact region R3b may be spaced apart from each other by the cell region insulating layer 190 therebetween.

The stack structure GS may include stack structures GS1-GS3 vertically stacked at a plurality of levels. In FIG. 2A and FIG. 2B, first, second, and third stack structures GS1, GS2, and GS3 may be included, but an example embodiment thereof is not limited thereto. For example, stack structures GS of four to eight levels of steps may be included. In some embodiments, the stack structure GS may be configured as stack structures GS of two levels. The level of each stack structure GS may be classified as a height of the stack structure at which a channel hole process for a predetermined depth of the channel structure CH may be enabled, and may be distinguished from each other by the channel portions (e.g., the first, second, and third channel portions CH1, CH2, and CH3) of the channel structure CH. The lower stack structure positioned on an upper surface of the conductive layer 101 may be referred to as the first stack structure GS1, and the stack structures GS2-GS3 on the first stack structure GS1 may be referred to as the second stack structure GS2, and the third stack structure GS3 in order.

In the stack structures GS1-GS3, gate electrodes 130 and interlayer insulating layers 120 may be alternately stacked in the vertical direction (e.g., the Z-direction), and the length in the vertical direction of each stack structure GS1-GS3 and the number of gate electrodes 130 of each stack structure GS1-GS3 may be (substantially) the same, but an example embodiment thereof is not limited thereto.

Referring to FIGS. 1, 2A, and 2B, the gate electrodes 130 may be isolated from each other in a second horizontal direction (e.g., a Y-direction) by isolation regions MS extending continuously from the memory region R1 to the extension region R2. The second horizontal direction may intersect (e.g. may be perpendicular to) the first horizontal direction. The gate electrodes 130 between a pair of (adjacent) isolation regions MS may form a single memory block BLK, but the range of the memory block BLK is not limited thereto. A portion of the gate electrodes 130, for example, the memory gate electrodes 130M, may form a single layer in the memory block BLK.

The gate electrodes 130 (e.g. other than the upper gate electrodes 130U) may be stacked vertically and spaced apart from each other in the memory region R1, the upper contact region R3, and the extension region R2, and may maintain a continuous plate shape without forming a step difference structure of a staircase shape in the memory region R1 and the extension region R2. Upper gate electrodes 130U may form a step difference structure of a staircase shape only in the upper contact region R3. The contact region of each gate electrode 130 may be a region in contact with the upper contact plugs MC1 as a pad region GP exposed by the staircase shape in the upper contact region R3, and may be defined as a region in contact with the wordline contact plugs MC2 in the extension region R2.

The gate electrodes 130 may include a conductive material layer 135, and the conductive material layer 135 may include, for example, W, Ru, Mo, Nb, Ni, Co, Ti, Ta, TiN, TaN, WN, NbN, TiAl, TiAlN, TiSi, TiSiN, TaSi, TaSiN, RuTiN, NiSi, CoSi and/or a combination thereof, but an example embodiment thereof is not limited thereto. According to example embodiments, the gate electrodes 130 may further include a diffusion barrier 132, and for example, the diffusion barrier 132 may include tungsten nitride (WN), tantalum nitride (TaN), titanium nitride (TiN) and/or a combination thereof.

The interlayer insulating layers 120 may be disposed between the (adjacent) gate electrodes 130 and may form the stack structure GS. The interlayer insulating layers 120 may be spaced apart from each other in a direction perpendicular to the upper surface of the conductive layer 101 (in the vertical direction (e.g., the Z-direction) and may extend in the first horizontal direction (e.g., the X-direction), similarly to the gate electrodes 130. The interlayer insulating layers 120 may include an insulating material such as silicon oxide and/or silicon nitride.

In example embodiments, thicknesses of the interlayer insulating layers 120 may be (generally and/or substantially) the same, but thicknesses of a portion thereof may not be the same. For example, the uppermost interlayer insulating layer 121 of the interlayer insulating layers 120 may have a thickness greater than thickness of the other interlayer insulating layers 120, but an example embodiment thereof is not limited thereto. In the description, the semiconductor device 100 may include a memory region R1, an upper contact region R3, and an extension region R2, but it may be understood that the stack structure GS may include a memory region R1, an upper contact region R3, and an extension region R2.

The isolation regions MS may extend into (e.g., penetrate) at least a portion of the gate electrodes 130 and may extend in the first horizontal direction (e.g., the X-direction). The isolation regions MS may successively cross the memory region R1, the upper contact region R3, and the extension region R2 and may extend in the first horizontal direction (e.g., the X-direction). The isolation regions MS may be disposed in parallel to each other. The isolation regions MS may penetrate the entire stacked gate electrodes 130 and may be connected to the conductive layer 101. The isolation regions MS may extend in the first horizontal direction (e.g., the X-direction) as an integrated region, but in some example embodiments, the isolation regions MS may extend intermittently or may be disposed only in partial regions. The isolation regions MS may have a line shape on the X-Y plane. In some embodiments, the isolation regions MS may have a shape in which a side surface has a continuous curved surface and extends in the first horizontal direction (e.g., the X-direction).

An isolation insulating layer may be disposed in the isolation regions MS. The isolation insulating layer may have a shape having a width decreasing toward the conductive layer 101 due to a high aspect ratio, but an example embodiment thereof is not limited thereto. An upper surface of the isolation insulating layer may be in contact with the first upper insulating layer 192, and a lower surface may be in contact with the upper surface of the conductive layer 101.

The insulating regions SS may extend in the first horizontal direction (e.g., the X-direction) between adjacent isolation regions MS. The insulating regions SS may selectively penetrate only the upper gate electrodes 130U1-130U7, that is, the erase gate electrodes 130U5-130U7 and the string select gate electrodes 130U1-130U4, and may divide the upper gate electrodes 130U among the stack structure GS (or between adjacent isolation regions MS) into a plurality of sub-sections.

Referring to FIG. 1, the insulating regions SS may extend in the first horizontal direction (e.g., the X-direction) across the memory region R1 and the upper contact region R3 (e.g., the first upper contact region R3a). The insulating regions SS may include a plurality of insulating regions SS parallel to each other between the isolation regions MS and may be spaced apart from each other in the second horizontal direction (e.g., the Y-direction), and may selectively isolate only the upper gate electrodes 130U.

The insulating regions SS may be disposed to have the same length in the vertical direction (e.g., the Z-direction) from an upper portion, and a lower surface may be disposed at a level lower than a level of the lower surface of the lowermost upper gate electrode 130U1 among the upper gate electrodes 130U, and may be disposed at a level higher than a level of the lower surface of the interlayer insulating layer 120 below (on the lower surface) the lowermost upper gate electrode 130U1. Accordingly, the upper gate electrodes 130U (of the memory region R1) may be completely penetrated by the insulating regions SS, and may also be isolated from the upper gate electrodes 130U of the extension region R3 by the staircase shape, thereby forming a plurality of sub-sections physically/electrically (completely) spaced apart from each other. Herein, the term "level", "vertical level", "height", or the like may refer to a relative location with respect to a reference element in the vertical direction (e.g., the Z-direction). A level, a vertical level, height, or the like may be a distance from an upper surface of the conductive layer 101 in the vertical direction. For example, a higher level may mean a farther distance from the upper surface of the conductive layer 101 in the vertical direction, and a lower level may mean a closer distance to the upper surface of the conductive layer 101 in the vertical direction.

As the insulating regions SS selectively penetrate only the upper gate electrode 130U and do not extend into (below) the memory gate electrode 130M, the memory gate electrodes 130M and the lower gate electrodes 130L may not be isolated by the insulating regions SS, and the memory gate electrodes 130M and the lower gate electrodes 130L in the memory region R1, the upper contact region R3, and the extension region R2 may be stacked in a single plate shape.

The insulating regions SS may be disposed across (overlap) a portion of the channel structures CH in the memory region R1. The insulating regions SS may have a predetermined width and may extend by crossing in the first horizontal direction (e.g., the X-direction) in a wavy shape between a plurality of channel structures CH arranged in a zigzag manner. Accordingly, when the plurality of channel structures CH are arranged to have the same spacing, the insulating regions SS may extend to cut (overlap) the channel structures CH at each apex of the wavy shape. The insulating regions SS may be recessed into an upper end portion of the channel structures CH, for example, a portion of the channel structures CH opposing the seven upper gate electrodes 130U, and accordingly, a portion of the channel structures CH may be removed. In this case, the channel structures CH may be recessed so as to cut, for example, (about) 1/3 to 1/4 of a circumference of an upper surface when viewed on the X-Y plane. The insulating regions SS may be disposed such that the insulating regions SS may not pass through the channel central axis of the channel structure CH and more than (about) 2/3 of the channel structure CH may remain on the upper surface, but an example embodiment thereof is not limited thereto. The channel structures CH into which the insulating regions SS are recessed may be effective channel structures which may actually function as memory cells, not dummy channel structures. The insulating regions SS may extend in a wavy shape in the memory region R1 and may extend in a line shape in the upper contact region R3 (in a plan view). In this case, widths of the wavy shape and the line shape may be maintained (substantially) the same, but an example embodiment thereof is not limited thereto. Each of the insulating regions SS may include an upper isolation insulating layer. The upper isolation insulating layer may include an insulating material, for example, silicon oxide, silicon nitride, and/or silicon oxynitride.

The channel structures CH may form rows and columns on the conductive layer 101 of the memory region R1 and may be spaced apart from each other. In the memory region R1, the channel structures CH may be disposed in a zigzag shape in one direction on the X-Y plane. The channel structures CH may extend into (e.g., penetrate) the gate electrodes 130, may extend in a vertical direction perpendicular to the upper surface of conductive layer 101, for example, in the vertical direction (e.g., the Z-direction), may have a pillar shape, and may have an inclined side surface of which a width may decrease toward the conductive layer 101 depending on an aspect ratio.

Each of channel structures CH may have a form in which k number of the stack structures GS1-GSk of the gate electrodes 130 penetrating k number of channel portions CH1-CHk (k is 1, 2, 3, or a positive integer) are (electrically) connected to each other. In an example embodiment, the first to third channel portions CH1-CH3 penetrating three stack structures GS1-GS3, respectively, may be (electrically) connected to each other.

As illustrated in the enlarged view in FIG. 3A, in each of the first to third channel portions CH1-CH3, a width of the upper end may be greater than that of the lower end, and due to a difference in widths between the upper end and the lower end, a side surface may be an inclined surface of which a width decreases toward the conductive layer 101. The lower end of the first to third channel portion CH1-CH3 of the upper portion and the upper end of the first to third channel portion CH1-CH3 of the lower portion may be (electrically) connected to each other and may form a bent portion. For example, an upper end of the first channel portion CH1 may be (electrically) connected to a lower end of the second channel portion CH2, and the upper end of the second channel portion CH2 may be (electrically) connected to a lower end of the third channel portion CH3. For example, the first to third channel portions CH1-CH3 may be connected to each other, end-to-end.

Each of the channel structures CH may include a first portion in the stack structure GS1-GS3 and a second portion protruding to a region below the stack structure GS1-GS3 and in contact with (extending into) the conductive layer 101.

A channel layer 140 may be disposed entirely in the first portion and the second portion of the channel structures CH, and may be disposed up to the upper end of the first portion. The channel layer 140 may include a protrusion portion protruding to a region below the stack structure GS1-GS3 and exposed, and a non-protrusion portion disposed in the first portion of the channel structure CH. The protrusion lengths (in the vertical direction) of the second portions (of the channel structures CH) and the protrusion portions of the channel layer 140 in the channel structures CH may not be the same, but an example embodiment thereof is not limited thereto. The channel layer 140 may be formed to have an annular shape of which a side surface may extend around (e.g., at least partially surround) a buried insulating layer 147 therein, but may also have a columnar shape such as a cylindrical shape or a prism shape without the buried insulating layer 147 according to an example embodiment. The protrusion portion of the channel layer 140 may extend into the conductive layer 101 and may be in direct contact with the conductive layer 101. The protrusion portion may be formed to have a gentle slope with respect to the non-protrusion portion such that the annular shape may be maintained as illustrated in FIG. 3A. The channel layer 140 may include, for example, a semiconductor material such as polycrystalline silicon and/or single crystal silicon, and the semiconductor material may be an undoped material or a material including P-type and/or N-type impurities.

Channel pads 149 may be disposed in an upper portion of the channel layer 140 in the channel structures CH. The channel pads 149 may be disposed to cover (or overlap in the vertical direction) an upper surface of the buried insulating layer 147 and to be electrically connected to the channel layer 140. The channel pads 149 may include, for example, doped polycrystalline silicon.

A channel dielectric layer 145 may be disposed between the gate electrodes 130 and the channel layer 140. The channel dielectric layer 145 may include a tunneling layer 141, a charge storage layer 142, and a blocking layer 143 stacked in order from the channel layer 140. The tunneling layer 141 may tunnel charges into the charge storage layer 142, and may include, for example, silicon oxide (e.g., SiO₂), silicon nitride (e.g., Si₃N₄), silicon oxynitride (e.g., SiON), and/or a combination thereof. The charge storage layer 142 may be a charge trap layer or a floating gate conductive layer. The blocking layer 143 may include, for example, silicon oxide (e.g., SiO₂), silicon nitride (e.g., Si₃N₄), silicon oxynitride (e.g., SiON), a high-κ dielectric material, and/or a combination thereof. A high-κ dielectric material may be a material having a dielectric constant that his greater than that of silicon oxide. According to example embodiments, (at least) a portion of the channel dielectric layer 145 may form a channel dielectric layer extending horizontally along the gate electrodes 130.

The channel dielectric layer 145 may be removed from below the stack structure GS1-GS3 such that the protrusion portion of the channel layer 140 may be exposed externally in the second portion (of the channel structure CH). Accordingly, the lower end of the channel dielectric layer 145 may be in contact with the conductive layer 101, and the side surface of the channel dielectric layer 145 may be disposed to extend around (at least partially surround) the non-protrusion portion of the channel layer 140 in the first portion (of the channel structure CH).

The channel layer 140, the channel dielectric layer 145, and the buried insulating layer 147 may be (electrically) connected to each other between the first to third channel portions CH1-CH3. For example, the channel layer 140 may be in contact with the channel dielectric layer 145 and the buried insulating layer 147.

The dummy channel structures DH may be disposed in the upper contact region R3 and may have a structure (substantially) the same as or similar to that of the channel structures CH, and may not perform an actual memory function in the semiconductor device 100. The dummy channel structures DH may be disposed regularly in rows and columns in the upper contact region R3. The dummy channel structures DH may extend around (surround) the upper contact plugs MC1, and as illustrated in FIG. 1, four dummy channel structures DH may be disposed around the upper contact plug MC1. The dummy channel structures DH may have a diameter (substantially) equal to or greater than a maximum diameter of the channel structures CH and a diameter smaller than a maximum diameter of the upper contact plugs MC1. The shape and the number of each of the dummy channel structures DH and/or a distance therebetween may be different. The channel structures CH and the dummy channel structures DH may have a circular shape or an almost circular shape (in a plan view), but an example embodiment thereof is not limited thereto. For example, the channel structures CH and the dummy channel structures DH may have an elliptical shape (in a plan view). The dummy channel structures DH may extend into (e.g., penetrate) the stack structure GS similarly to the channel structures CH, and the channel dielectric layer 145 may be disposed in the region inserted into the conductive layer 101, such that the channel layer 140 may not be exposed, and an insulating state with the conductive layer 101 may be maintained. For example, the channel layer 140 in the dummy channel structure DH may be spaced apart from the conductive layer 101 by the channel dielectric layer 145 in the dummy channel structure DH. The dummy channel structures DH may be a supporter which may prevent deformation such as warpage of the stack structure GS.

The support structures SH may be disposed in the extension region R2. The support structures SH may have a different structure from the dummy channel structures DH. The support structures SH may be disposed regularly in rows and columns in the extension region R2. The support structures SH may have a diameter greater than a maximum diameter of the channel structures CH and may have a diameter smaller than a maximum diameter of the wordline contact plugs MC2. The shape and the number of the support structures SH and/or a distance therebetween may be varied. The support structures SH may have a circular shape or an almost circular shape (in a plan view), but an example embodiment thereof is not limited thereto. For example, the support structures SH may have an elliptical shape in a plan view. The support structures SH may extend into (e.g., penetrate) the stack structure GS similarly to the channel structures CH and may include a vertical portion extending in the vertical direction (e.g., the Z-direction) and a horizontal portion protruding from the vertical portion toward each gate electrode 130, but an example embodiment thereof is not limited thereto. The support structures SH may also have a structure including a plurality of bent portions corresponding to the bent portions of the first to third channel portions CH1-CH3 of the channel structure CH. The support structures SH may be configured as a supporter for preventing deformation such as warpage of the stack structure GS.

The semiconductor device 100 may include contact plugs MC1 and MC2 (electrically) connected to gate electrodes 130, respectively, in the upper contact region R3 and the extension region R2. The contact plugs MC1 and MC2 may extend into (e.g., penetrate) the first upper insulating layer 192, the uppermost interlayer insulating layer 121, and/or the cell region insulating layer 190, and may extend downwardly in the vertical direction (e.g., the Z-direction) and may be (electrically) connected to upper surfaces of the allocated gate electrodes 130. The contact plugs MC1 and MC2 may have a circular or elliptical shape on the X-Y plane as illustrated in FIG. 1, and may be spaced apart from each other in the first horizontal direction (e.g., the X-direction) and the second horizontal direction (e.g., the Y-direction). The contact plugs MC1 and MC2 may be arranged in a lattice shape or a zigzag shape, and the arrangements and the shapes of the upper contact plugs MC1 and the wordline contact plugs MC2 may be different from each other.

The wordline contact plugs MC2 may be arranged in a zigzag pattern alternately in rows in the extension region R2, and the upper contact plugs MC1 may be arranged in rows in subregions distinct by the isolation region SS.

The upper contact plugs MC1 may be disposed in the upper contact region R3, and may be (electrically) connected to a predetermined number of upper gate electrodes 130U functioning as erase gate electrodes 130U5-130U7 among the upper gate electrodes 130U and a predetermined number of upper gate electrodes 130U functioning as string select gate electrodes 130U1-130U4, respectively.

In FIGS. 1, 2A, and 2B, it is illustrated that the number of the erase gate electrodes 130U5-130U7 may be three and the number of the string select gate electrodes 130U1-130U4 may be four, and accordingly, seven upper contact plugs MC1 (electrically) connected to the upper gate electrodes 130U1-130U7 may be disposed in each sub-section. That is, the upper contact plugs MC1 (electrically) connected to the upper gate electrodes 130U, respectively, may be disposed in the sub-sections of the upper gate electrodes 130U divided by the insulating regions SS.

In an example embodiment, the upper gate electrodes 130U may have a step difference structure of a staircase shape such that each pad region GP may be exposed in the upper contact region R3. In this case, the length of the pad region GP in the first horizontal direction (e.g., the X-direction), that is, a length of the staircase (e.g. the length of each step in the first horizontal direction), may be smaller in the erase gate electrodes 130U5-130U7 than the pad region GP of the string select gate electrodes 130U1-130U4. For example, the length of the pad region GP of one of the erase gate electrodes 130U5-130U7may be (about) 1/4 to 1/2 of the length of the pad region GP of one of the string select gate electrodes 130U-130U4, but an example embodiment thereof is not limited thereto.

The upper contact plugs MC1 (electrically) connected to one of the erase gate electrodes 130U5-130U7 may be (electrically) connected to each other by an erase line in upper portions thereof, such that a length of the pad region GP corresponding to an erase line may be required, and the string select gate electrodes 130U1-130U4 may be (electrically) connected to different string lines in each sub-section, respectively, such that a length of the pad region GP at which at least four circuit interconnections may be spaced apart from each other may be required. However, the length of the pad region GP may be implemented in various manners depending on a circuit design.

In each sub-section, one upper contact plug MC1 may be (electrically) connected to one upper gate electrode 130U, but in some embodiments, a plurality of upper contact plugs MC1 may be (electrically) connected to one upper gate electrode 130U. Accordingly, the number of the upper contact plugs MC1 allocated to each sub-section may be the same, and the number of the upper contact plugs MC1 allocated to each sub-section may satisfy an integer multiple of the number of the upper gate electrodes 130U.

In each sub-section, the upper gate electrodes 130U1-130U4 may be individually connected to each other by four string select contact plugs MC1 and may transfer electrical signals, thereby selecting the channel structure CH of the corresponding sub-sections.

The upper contact plugs MC1 may include a conductive layer, and may be implemented as a pillar shape extending in the vertical direction (e.g., the Z direction) such that the pad regions GP and the lower surface of the first to seventh upper gate electrodes 130U1-130U7 may be in contact with each other. Specifically, the upper contact plugs MC1 may extend in the vertical direction (e.g., the Z direction) from the first upper insulating layer 192 to extend into (e.g., penetrate) the uppermost interlayer insulating layer 121 or the cell region insulating layer 190 and to be in contact with the pad region GP of the allocated upper gate electrodes 130U.

The upper surface of the upper contact plugs MC1 may be positioned at (substantially) the same level as (coplanar with) an upper surface of the first upper insulating layer 192, and a lower surface may be positioned at (substantially) the same or lower level as an upper surface of the allocated upper gate electrode 130U in the pad region GP of the allocated upper gate electrode 130U. Any features that are described as being coplanar with each other, may be considered to be located on the same level (e.g. the same vertical level). An upper surface of the upper contact plugs MC1 may have a circular shape or an elliptical shape when viewed on the X-Y plane, a width W1 of the upper surface may be greater than the width W3 of the lower surface, an inclined side surface may be disposed between the upper surface and the lower surface. Each side surface of the upper contact plugs MC1 may have a continuously sloped inclined surface without a bent portion, but an example embodiment thereof is not limited thereto.

An upper side-surface insulating layer 175 may be further disposed on an upper region of a side surface of the upper contact plugs MC1. The upper side-surface insulating layer 175 may extend around (e.g., surround) the upper region of the side surface of the upper contact plugs MC1 and may have a ring shape. An upper end of the upper side-surface insulating layer 175 may be coplanar with an upper surface of the upper contact plugs MC1, and a lower end of the upper side-surface insulating layer 175 may be positioned at a level higher than a level of a lower surface of the upper contact plugs MC1. In some embodiments, the lower end of the upper side-surface insulating layer 175 may be coplanar with a lower surface of the first upper insulating layer 192. In some embodiments, the lower end of the upper side-surface insulating layer 175 may be coplanar with an upper surface of the uppermost interlayer insulating layer 121 or an upper surface of the cell region insulating layer 190.

As described above, the upper side-surface insulating layer 175 may be disposed between the first upper insulating layer 192 and a side surface of the upper contact plugs MC1, and may be in direct contact with an upper region of a side surface of the upper contact plugs MC1. The upper side-surface insulating layer 175 may be disposed to have a substantially uniform side-surface thickness ta from an upper end to a lower end, and may be disposed in a shape in which the upper side-surface insulating layer 175 extends around (e.g., surrounds) an upper region of the circular upper contact plugs MC1 in a ring shape on the X-Y plane. The side-surface thickness ta may be less (e.g., smaller) than a thickness of the interlayer insulating layer 120. For example, the side-surface thickness ta may be 400Å to 500Å. For example, the side-surface thickness ta may be (about) 450Å, but an example embodiment thereof is not limited thereto. The upper side-surface insulating layer 175 may be formed to have a length in the vertical direction (e.g., the Z-direction) (substantially) the same as the thickness t1 of the first upper insulating layer 192. Accordingly, an upper region of the side surface of the upper contact plugs MC1 may be in contact with the upper side-surface insulating layer 175, and a lower region of the side surface of the upper contact plugs MC1 may be in contact with the uppermost interlayer insulating layer 121 or the cell region insulating layer 190. As described above, the side surface of the upper contact plugs MC1 may be in contact with different insulating layers depending on levels.

The upper side-surface insulating layer 175 may include an atomic layer deposition (ALD) insulating material, and for example, silicon oxide, undoped polysilicon, and/or silicon nitride may be formed with a uniform thickness ta by an ALD process. Accordingly, the insulating material formed by the ALD process may have a significantly lower density even when the same material as that of the first upper insulating layer 192, the interlayer insulating layer 120, or the cell region insulating layer 190 is included.

The upper contact plugs MC1 and the upper side-surface insulating layer 175 as described above may be referred to as an upper contact structure CS1.

The wordline contact plugs MC2 may include a conductive layer, may fill a central region of a contact hole, and may have a pillar shape extending in the vertical direction (e.g., the Z-direction) from an upper surface coplanar with the upper surface of the first upper insulating layer 192 to a lower surface in contact with the allocated gate electrode 130. The wordline contact plugs MC2 may include a bent portion (e.g. similar to the channel structures CH) depending on a length, and a width W4 of the upper surface of the wordline contact plugs MC2 may be greater than the width of the lower surface thereof, and an inclined side surface may be disposed between the upper surface and the lower surface. The upper surface of the wordline contact plugs MC2 may be coplanar with the upper surface of the upper contact plugs MC1, and may be coplanar with the upper surface of the first upper insulating layer 192. A contact barrier layer may be further included on a side surface and a lower surface of the conductive layer, but an example embodiment thereof is not limited thereto.

The first side-surface insulating layer 160 may be disposed between the stack structures GS through which the wordline contact plugs MC2 extend into (e.g., penetrate) and the wordline contact plugs MC2. The first side-surface insulating layer 160 may be disposed on the side surface of the wordline contact plugs MC2, and may be disposed such that the upper end may be positioned at a level lower than a level of the upper surface of the wordline contact plugs MC2, and the lower end may be positioned at a level (substantially) equal to or higher than a level of the lower surface of the wordline contact plugs MC2. A lower end of the first side-surface insulating layer 160 may be disposed to expose the upper surface of the allocated gate electrode 130, and may be disposed to insulate the gate electrodes 130 in an upper portion of the allocated gate electrode 130.

A second side-surface insulating layer 170 may be disposed between the first side-surface insulating layer 160 and the wordline contact plugs MC2. The second side-surface insulating layer 170 may be in direct contact with a side surface of the wordline contact plugs MC2, may have an upper end at (substantially) the same level as an upper surface of the wordline contact plugs MC2 and a lower end at (substantially) the same level as a lower end of the first side-surface insulating layer 160. Accordingly, the upper end of the second side-surface insulating layer 170 may be positioned at a level higher than a level of the upper end of the first side-surface insulating layer 160 and may extend into (e.g., penetrate) the first upper insulating layer 192. Accordingly, the upper surface of the wordline contact plugs MC2 and the upper end of the second side-surface insulating layer 170 may be exposed on the first upper insulating layer 192, and the upper end of the first side-surface insulating layer 160 may not be exposed. The first upper insulating layer 192, the upper surface of the wordline contact plugs MC2 and the upper end of the second side-surface insulating layer 170 may be (substantially) coplanar with each other, but an example embodiment thereof is not limited thereto.

The second side-surface insulating layer 170 may be disposed to have a (substantially) uniform side-surface thickness ta from an upper end to a lower end, and the side-surface thickness ta may be (substantially) equal to or greater than the thickness of the first side-surface insulating layer 160. In some embodiments, the side-surface thickness ta may be less than the thickness of the interlayer insulating layers 120. The second side-surface insulating layer 170 may include the same material as that of an upper side-surface insulating layer 175 of the upper contact structure CS1 and may have the same thickness ta, and the level of the upper end may be (substantially) the same.

The first side-surface insulating layers 160 may include an insulating material, for example, silicon oxide, silicon nitride, and/or silicon oxynitride. The second side-surface insulating layer 170 may include an ALD insulating layer, such as the upper side-surface insulating layer 175, and may include silicon oxide, undoped polysilicon, and/or silicon nitride. Even when the first side-surface insulating layer 160 and the second side-surface insulating layer 170 include the same material, a degree of density of the second side-surface insulating layer 170 may be lower than that of the first side-surface insulating layer 160 depending on the formation process. As described above, the first side-surface insulating layer 160, the second side-surface insulating layer 170, and the wordline contact plug MC2 may be referred to as a wordline contact structure CS2, but an example embodiment thereof is not limited thereto. The first and second side-surface insulating layers 160 and 170 may electrically insulate the gate electrodes 130 adjacent to the wordline contact plugs MC2 by extending around (e.g., surrounding) the side surfaces of the wordline contact plugs MC2. The wordline contact plugs MC2 may be physically and electrically contact with the contact region of the allocated gate electrode 130 through the exposed lower surface of the wordline contact plugs MC2. For example, at least a portion of a side surface of the wordline contact plugs MC2 may be spaced apart from the gate electrodes 130 by the first and second side-surface insulating layers 160 and 170, and a lower surface of the wordline contact plugs MC2 may be in contact with the gate electrodes 130.

**In** the extension region R2, when the wordline contact plugs MC2 (electrically) connected to the memory gate electrodes 130M and the lower gate electrodes 130L are allocated one by one, the wordline contact plugs MC2 may be disposed with different lengths so as to be (electrically) connected to the gate electrodes 130 (e.g., the memory gate electrodes 130M and the lower gate electrodes 130L) of different levels.

In the example embodiment in FIGS. 2A, 2B, 3A, 3B, and 3C, it is illustrated that each of the first to third stack structures GS1-GS3 may include gate electrodes 130 of 8-step (e.g. 8 gate electrodes 130 per stack structure) (i.e. 24 gate electrodes 130 in total), and since the 7 gate electrodes 130 at the upper portion of the first to third stack structure GS1-GS3 are upper gate electrodes 130U, 17 gate electrodes 130 (e.g., the memory gate electrodes 130M and the lower gate electrodes 130L) remain. Wordline contact plugs MC2 of which lengths are adjusted differently so as to be in contact with the upper surfaces of the 17 gate electrodes 130 (e.g., the memory gate electrodes 130M and the lower gate electrodes 130L may be disposed in the extension region R2.

The arrangement of the wordline contact plugs MC2 may be varied, and in an example embodiment, it is illustrated that, as in FIG. 1, the gate electrodes 130 may be arranged such that the gate electrodes 130 may be lowered by one layer in the vertical direction (e.g., the Z-direction) in the second horizontal direction (e.g., the Y-direction) in a column and may be in contact with the allocated gate electrodes 130, respectively. Accordingly, as illustrated in FIG. 2A, the length in the vertical direction (e.g., the Z-direction) of the wordline contact plugs MC2, arranged in the first horizontal direction (e.g., the X-direction), may be lengthened so as to be in contact with the 9th, 12th, and 23rd gate electrodes 130, respectively, when the uppermost gate electrode 130 is referred to as the first gate electrode 130U7. The lengthening of the length in the vertical direction (e.g., Z-direction) of the wordline contact plugs MC2 may be defined as that the level of the upper surface may be the same and the level of the lower surface may be lowered.

As described above, the wordline contact plugs MC2 may be arranged to have a longer length in a direction away from the memory region R1 in the first horizontal direction (e.g., the X-direction), and the wordline contact plugs MC2 may be arranged to have a longer length downwardly in the second horizontal direction (e.g., the Y-direction), but an example embodiment thereof is not limited thereto. For example, the wordline contact plugs MC2 may be arranged in a single row, and may be arranged symmetrically such that the length may increase toward a center of the extension region R2. The wordline contact plugs MC2 disposed in the last row may include dummy wordline contact plugs MC2, and may function as a support structure SH without performing the function of selecting an actual wordline.

The upper contact plugs MC1 and the wordline contact plugs MC2 may include the same conductive material, for example, tungsten (W), copper (Cu), aluminum (Al), and/or an alloy thereof. For example, the conductive layer may include tungsten (W). The contact barrier layer may include tungsten nitride (WN), tantalum nitride (TaN), titanium nitride (TiN), and/or a combination thereof.

The cell region insulating layer 190 may be disposed to overlap or cover the stack structure GS, and specifically, the cell region insulating layer 190 may be disposed to overlap or cover a space in the upper contact region R3. The cell region insulating layer 190 may include (e.g., may be formed of), for example, an insulating material, such as silicon oxide, silicon nitride, and/or silicon oxynitride.

A first upper insulating layer 192 and a second upper insulating layer 194 may be stacked in order on the cell region insulating layer 190 and the uppermost interlayer insulating layer 121.

The first upper insulating layer 192 may be disposed to have a first thickness t1, may be penetrated by the contact plugs MC1 and MC2, may be penetrated by the upper side-surface insulating layer 175, and may be penetrated by the second side-surface insulating layer 170. The upper contact plugs MC1, the wordline contact plugs MC2, the upper side-surface insulating layer 175, and the second side-surface insulating layer 170 may extend into the first upper insulating layer 192.

The second upper insulating layer 194 may be disposed on the first upper insulating layer 192, and may be penetrated by studs 180a, 180b, and 180c on each of contact plugs MC1 and MC2. For example, the first, second, and third studs 180a, 180b, and 180c may extend into the second upper insulating layer 194. The first and second upper insulating layers 192 and 194 may include the same insulating material, but an example embodiment thereof is not limited thereto, and the first and second upper insulating layers 192 and 194 may include, for example, SiO, SiN, SiCN, SiOC, SiON, and/or SiOCN. The first upper insulating layer 192 may be in direct contact with outer side surfaces of the upper side-surface insulating layer 175 and the second side-surface insulating layer 170, and may include the same material as that of the upper side-surface insulating layer 175 and the second side-surface insulating layer 170. However, the first upper insulating layer 192 may be formed in a different manner from the upper side-surface insulating layer 175 and the second side-surface insulating layer 170, such that the layers may have different degrees of density. Specifically, the upper side-surface insulating layer 175 and the second side-surface insulating layer 170 may be formed by an ALD method, and the first upper insulating layer 192 may be formed by a CVD (chemical vapor deposition) method, such that the degrees of density of the upper side-surface insulating layer 175 and the second side-surface insulating layer 170 may be lower than the degree of density of the first upper insulating layer 192.

The studs 180a, 180b, and 180c and the cell interconnection lines 185 may be disposed. The studs 180a, 180b, and 180c may include first studs 180a extending into (e.g., penetrating) the second upper insulating layer 194 in the upper contact region R3 and in contact with the upper surface of the upper contact plugs MC1, and second studs 180b disposed in the extension region R2, extending into (e.g., penetrating) the second upper insulating layer 194, and in contact with the upper surface of the wordline contact plugs MC2. The studs 180a, 180b, and 180c may further include third studs 180c disposed in the memory region R1, extending into (e.g., penetrating) both the first and second upper insulating layers 192 and 194, connected to the channel pad 149 of the channel structures CH, and electrically connected to the channel layers 140.

Upper surfaces of the first and second studs 180a and 180b may be positioned at the same level, and lower surfaces of the first and second studs 180a and 180b may be positioned at the same level. The upper surfaces of the first and second studs 180a and 180b may be coplanar with each other. The lower surfaces of the first and second studs 180a and 180b may be coplanar with each other. The first and second studs 180a and 180b may be formed with the same length (in the vertical direction), and may have an inclined side surface having a width decreasing from the upper surface to the lower surface. The upper surfaces of the first and second studs 180a and 180b may have the same upper surface width W2, and the upper surface width W2 of the first and second studs 180a and 180b may be less (smaller) than the upper surface width W1 of the first contact plug MC1, and may be (substantially) equal to or less (smaller) than the lower surface width W3 of the first contact plug MC1. The upper surface width W2 of the first and second studs 180a and 180b may be, for example, about 100 nm, but an example embodiment thereof is not limited thereto.

The first and second studs 180a and 180b may be electrically connected to the gate electrodes 130, respectively, by the contact plugs MC1 and MC2 (electrically) connected to the lower surfaces thereof, respectively. Each of the studs 180a, 180b, and 180c may have a plug shape, and each of the cell interconnection lines 185 may have a line shape, but an example embodiment thereof is not limited thereto. The first and second studs 180a and 180b may include the same material, and may include a metal. For example, they may include tungsten (W), copper (Cu), aluminum (Al), or the like.

The cell interconnection lines 185 may include a metal, for example, tungsten (W), copper (Cu), aluminum (Al), or the like. An insulating layer may be further disposed to cover the cell interconnection lines 185. The insulating layer may include (e.g., may be formed of) an insulating material, for example, SiO, SiN, SiCN, SiOC, SiON, and/or SiOCN.

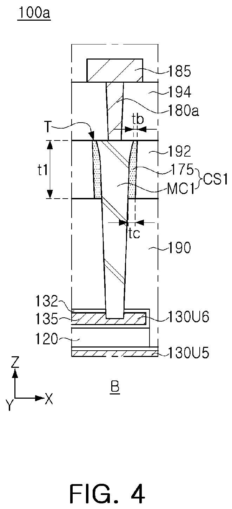

FIGS. 4 to 7 are enlarged cross-sectional views illustrating a semiconductor device according to example embodiments.

The semiconductor device 100a in FIG. 4 may be (substantially) the same as or similar to the semiconductor device 100 in FIGS. 1, 2A, 2B, 3A, 3B, and 3C. The shape of the upper contact structure CS1 may be the main difference.

A width W1 of an upper surface of the upper contact plug MC1 may be greater than a width W3 of a lower surface, and the upper contact plug MC1 may have an inclined side surface of which a width decreases toward the lower surface. An upper region of the side surface bent with the upper surface of the upper contact plug MC1 may be formed to be curved as a width may be rapidly reduced. Accordingly, the side surface may include a curved region having an inflection point, and the curved region may be included in the upper region. The curved region of the upper contact plug MC1 may be disposed relatively close to the upper surface, such that the side surface connected to an edge T bent from the upper surface may have a curved region. A slope of the upper contact plug MC1 may increase downwardly. Within the curved region, the rate of change of the width of the upper contact plug MC1 may decrease as the upper contact plug MC1 extends downwardly.

An upper side-surface insulating layer 175 extending around (e.g., surrounding) an upper region of a side surface of the upper contact plug MC1 may be disposed. The upper side-surface insulating layer 175 may have a thickness tb of the upper portion (in the first horizontal direction) smaller than a thickness tc of the lower portion (in the first horizontal direction). The upper side-surface insulating layer 175 may have a ring shape and may include an inner side surface in contact with the upper contact plug MC1 and an outer side surface in contact with the first upper insulating layer 192 between the upper end and the lower end of the upper side-surface insulating layer 175. A slope of an inner side surface of the upper side-surface insulating layer 175 and a slope of an outer side surface may be different from each other. The outer side surface of the upper side-surface insulating layer 175 may have a constant slope from the upper end to the lower end of the upper side-surface insulating layer 175, and the inner side surface may have an inflection point at which a slope changes from the upper end to the lower end of the upper side-surface insulating layer 175. The inflection point of the inner side surface may be the same as the inflection point of a side surface of the upper contact plug MC1, and may be inclined from the inner side surface toward the outer side surface such that the thickness tb of an upper portion of the upper side-surface insulating layer 175 may decrease. The width of an upper region of the upper contact plug MC1 may increase by the decrease in the thickness tb of an upper portion of the upper side-surface insulating layer 175, such that the upper region (of the upper contact plug MC1) may have an expanded width. In FIG. 4, the shapes of the upper contact plug MC1 and the upper side-surface insulating layer 175 may be modified. In some embodiments, the shape of an upper portion of the wordline contact plug MC2 and the second side-surface insulating layer 170 may be formed to include a curved region that is (substantially) the same or similar to the curved region as illustrated in FIG. 4.

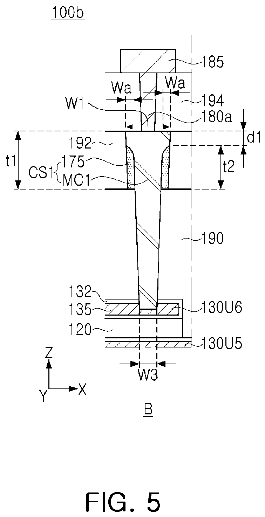

The semiconductor device 100b in FIG. 5 may be (substantially) the same as or similar to the semiconductor device 100 in FIGS. 1, 2A, 2B, 3A, 3B, and 3C. The shape of the upper contact structure CS1 may be the main difference.

A width W1 of the upper surface of the upper contact plug MC1 may be greater than a width W3 of the lower surface, and may have an inclined side surface of which a width decreases toward the lower surface, and may include an expansion region having an expanded width Wa (in the first horizontal direction) in the upper region. The expansion region of the upper contact plug MC1 may include a width Wa extending to an edge by a predetermined distance from the width W1 of the upper surface in FIG. 3B.

In the expansion region of the upper contact plug MC1, a side surface of the upper contact plug MC1 may be in direct contact with the first upper insulating layer 192 by a first length d1 (e.g. in the vertical direction (e.g., Z-direction)). A side surface of the upper contact plug MC1 may include the expansion region having a linear slope by the first length d1 and a curved region in which a width decreases rapidly below the first length d1. The curved region may be disposed consecutively with the expansion region, and may be disposed in an upper region of the upper contact plug MC1.

An upper side-surface insulating layer 175 extending around (e.g., surrounding) an upper region of the side surface of the upper contact plug MC1 may be disposed on (in) the curved region of the upper contact plug MC1. The upper side-surface insulating layer 175 may have a thickness increasing from the upper end to the lower end. The upper side-surface insulating layer 175 may have a ring shape, and may include an inner side surface in contact with the upper contact plug MC1 between the upper end and the lower end, and an outer side surface in contact with the first upper insulating layer 192, and a slope of the inner side surface and a slope of the outer side surface may be different from each other. The outer side surface of the upper side-surface insulating layer 175 may have a constant slope downwardly, and the slope of the outer side surface may be continuous with the slope of the side surface of the expansion region. The inner side surface of the upper side-surface insulating layer 175 may have an inflection point at which a slope may change from the upper end to the lower end. The inflection point of the inner side surface may be the same as the inflection point of the side surface of the upper contact plug MC1, and the inner side surface and the outer side surface of the upper side-surface insulating layer 175 may meet each of as a line on an upper end, and the thickness may start from 0 and may gradually increase toward the lower surface. The width of the upper region of the upper contact plug MC1 may increase by a decrease in thickness of the upper portion of the upper side-surface insulating layer 175, and the upper side-surface insulating layer 175 may not be present in the uppermost region of the upper contact plug MC1, and the expansion region in which the first upper insulating layer 192 and the side surface of the upper contact plug MC1 are in direct contact with each other may be disposed.

Accordingly, the upper end of the upper side-surface insulating layer 175 may be disposed at a level lower than a level of the upper surface of the upper contact plug MC1, and the lower end may be disposed at a level higher than a level of the lower surface of the upper contact plug MC1. In some embodiments, the lower end of the upper side-surface insulating layer 175 may be coplanar with the lower surface of the first upper insulating layer 192. The length t2 in the vertical direction (e.g., the Z-direction) of the upper side-surface insulating layer 175 may be less (smaller) than the first thickness t1 of the first upper insulating layer 192. In FIG. 5, the shapes of the upper contact plug MC1 and the upper side-surface insulating layer 175 may be modified, and the shapes of upper portions of the wordline contact plug MC2 and the second side-surface insulating layer 170 may also be formed to include an expansion region and a curved region as illustrated in FIG. 5.

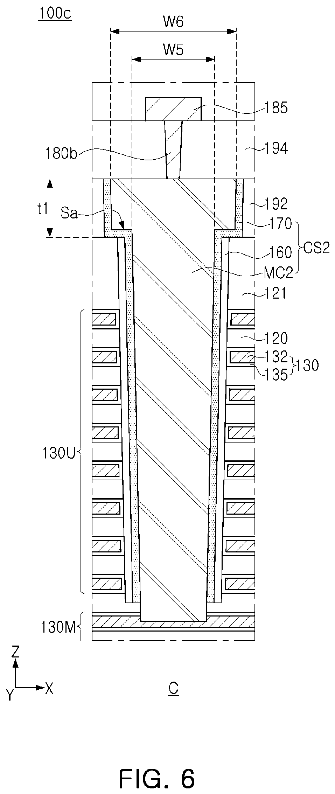

The semiconductor device 100c in FIG. 6 may be substantially the same as or similar to the semiconductor device 100 in FIGS. 1, 2A, 2B, 3A, 3B, and 3C. The shape of the wordline contact structure CS2 may be the main difference.

The wordline contact plugs MC2 in FIG. 6 may include an upper region having an expanded width W6 in the upper region. The expanded width W6 of the upper surface of the wordline contact plugs MC2 may be greater than a width W4 of the upper surface in FIG. 3C. The upper region may have a width decreasing downwardly, and a lower end of the upper region and an upper end of the lower region connected below the upper region may have different widths. Accordingly, the bent portion Sa in which the width of the lower end of the upper region is greater than the width W5 of the upper end of the lower region may be included, and the bent portion Sa may be positioned at a level (substantially) similar to a level of the lower surface of the first upper insulating layer 192. In some embodiments, the bent portion Sa may be higher than the lower surface of the first upper insulating layer 192 by the thickness of the second side-surface insulating layer 170.

A width of the lower region of the wordline contact plugs MC2 may decrease from the upper end (of the lower region) to the lower surface of the wordline contact plugs MC2, and the width may decrease uniformly.

By having an expanded width W6 in an upper region of the wordline contact plugs MC2, misalignment with the studs 180b in the upper portion may be reduced (e.g., prevented).

The second side-surface insulating layer 170 may be formed to be bent along the side surface of the wordline contact plugs MC2 having the bent portion Sa. Even when the second side-surface insulating layer 170 is formed to be bent along the bent portion Sa of the wordline contact plugs MC2, the same thickness may be maintained. Accordingly, the second side-surface insulating layer 170 may extend to the side surface of the lower region (of the second side-surface insulating layer 170) by being bent along the side surface of the wordline contact plugs MC2 from the upper end (of the second side-surface insulating layer 170) coplanar with the first upper insulating layer 192.

The first side-surface insulating layer 160 may be disposed below the bent portion Sa, that is, between the lower region of the wordline contact plugs MC2 and the stack structures GS, and accordingly, the upper end of the first side-surface insulating layer 160 may be spaced apart from the bent portion Sa by the second side-surface insulating layer 170, and the first side-surface insulating layer 160 may not extend around (not surround) the bent portion Sa and the expansion region (the upper portion of the wordline contact plugs MC2).

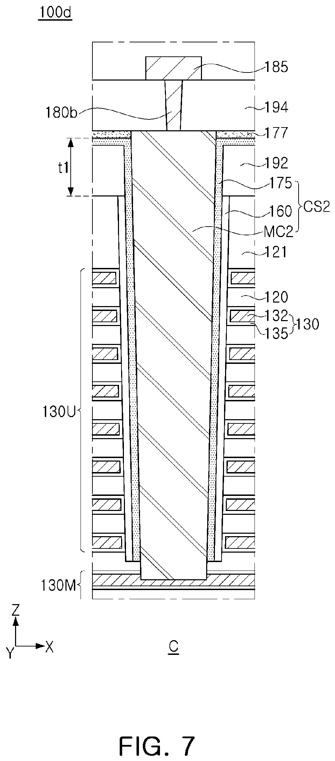

The semiconductor device 100d in FIG. 7 may be (substantially) the same as or similar to the semiconductor device 100 in FIGS. 1, 2A, 2B, 3A, 3B, and 3C. The blocking insulating layer 177 and the shape of the upper side-surface insulating layer 175 may be the main differences.

The semiconductor device 100d in FIG. 7 may further include a blocking insulating layer 177 between the first upper insulating layer 192 and the second upper insulating layer 194.

The blocking insulating layer 177 may be configured as a blocking layer for protecting the first upper insulating layer 192, the second side-surface insulating layer 170, and the upper side-surface insulating layer 175 during an etch-back process of etching the cell region insulating layer 190 from lower surfaces of the first and second side-surface insulating layers 160 and 170 and the upper side-surface insulating layer 175 on the lower surface of each contact hole by etching-back. The blocking insulating layer 177 may include, for example, a carbide layer and/or a nitride layer, but an example embodiment thereof is not limited thereto.

The blocking insulating layer 177 may be disposed to expose each of upper ends of the contact structures MC1 and MC2. A lower surface of the blocking insulating layer 177 may be in contact with the second side-surface insulating layer 170 and the upper side-surface insulating layer 175.

The blocking insulating layer 177 may be disposed between the first and second upper insulating layers 192 and 194, may be a different material from the first and second upper insulating layers 192 and 194, and may have a thickness (significantly) less (smaller) than (each of) those of the first and second upper insulating layers 192 and 194.

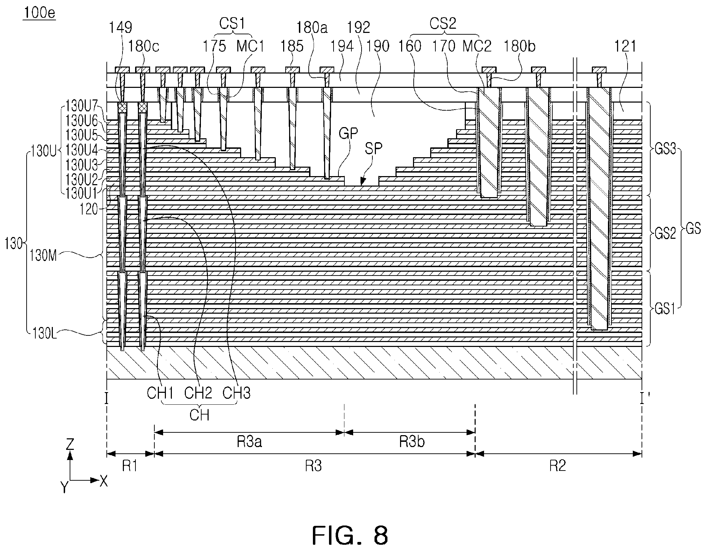

Hereinafter, semiconductor devices according to example embodiments will be described with reference to FIGS. 8 to 10.

Referring to FIG. 8, the semiconductor device 100e may be (substantially) the same as or similar to the semiconductor device 100 in FIGS. 1, 2A, 2B, 3A, 3B, and 3C. The structure of the upper gate electrodes 130U may be the main difference.

The upper gate electrodes 130U may include a pad region GP to be in contact with the upper contact plug MC1 in the first upper contact region R3a, and may include a step difference structure having a staircase shape such that the pad region GP may be exposed.

When seven upper gate electrodes 130U1-130U7 are allocated, the seven upper gate electrodes 130U1-130U7 may have a step difference structure in a staircase shape of which a length increases downwardly. Accordingly, a dummy step difference structure having a staircase shape may also be formed in the second upper contact region R3b on the opposite side (in the first horizontal direction). The dummy step difference structure of the second upper contact region R3b on the opposite side may have a staircase shape of which a length may be shortened upwardly. A staircase width of the dummy step difference structure of the second upper contact region R3b and a staircase width of the step difference structure of the first upper contact region R3a may be different from each other. For example, the staircase width of the dummy step difference structure of the second upper contact region R3b may be narrower than the staircase width of the step difference structure of the upper contact region R3a, and may be asymmetrically with respect to the buffer region SP (in the first horizontal direction).

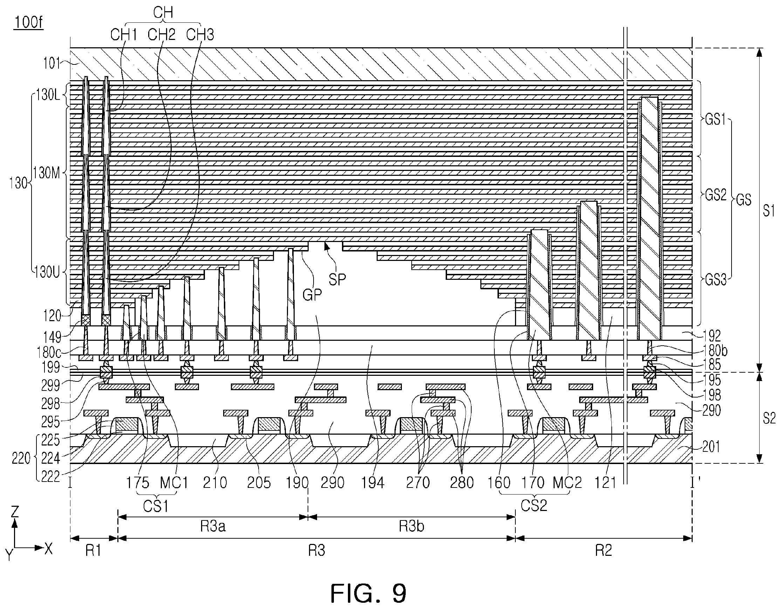

The semiconductor device 100f in FIG. 9 may include the semiconductor device 100 in FIGS. 1, 2A, 2B, 3A, 3B, and 3C as the first semiconductor structure S1, and the second semiconductor structure S2 may be disposed as a peripheral circuit structure below the first semiconductor structure S1. The first semiconductor structure S1 may be stacked on the second semiconductor structure S2. Specifically, the first semiconductor structure S1 may be disposed in the upper portion in the vertical direction (e.g., the Z-direction) with respect to the second semiconductor structure S2. In example embodiments, the second semiconductor structure S2 may be disposed on an upper portion of the first semiconductor structure S1. As an example, the upper portion (e.g., an upper surface) of the first semiconductor structure S1 illustrated in FIGS. 1, 2A, 2B, 3A, 3B, and 3C may faces downwardly in FIG. 9.

The first semiconductor structure S1 may further include a bonding structure. Specifically, first bonding vias 195, first bonding metal layers 198, and first bonding insulating layer 199 may form a first bonding structure of the first semiconductor structure S1. The first bonding vias 195 may be disposed on cell interconnection lines 185, and the first bonding metal layers 198 may be (electrically) connected to the first bonding vias 195. The first bonding metal layers 198 may have an upper surface exposed to an upper surface of the first semiconductor structure S1. The first bonding metal layers 198 may be bonded and (electrically) connected to second bonding metal layers 298 of the second semiconductor structure S2. The first bonding vias 195 and the first bonding metal layers 198 may include a conductive material, for example, copper (Cu). The first bonding insulating layer 199 may form dielectric-dielectric bonding with the second bonding insulating layer 299 of the second semiconductor structure S2.

The second semiconductor structure S2 may include a substrate 201, source/drain regions 205 and device isolation layers 210 in the substrate 201, circuit devices 220 disposed on (in) the substrate 201, a peripheral region insulating layer 290, circuit contact plugs 270, circuit interconnection lines 280, second bonding vias 295, and second bonding metal layers 298.

The substrate 201 may have a lower surface extending in the first horizontal direction (e.g., the X-direction) and the second horizontal direction (e.g., the Y-direction). An active region may be defined by the device isolation layers 210 in the substrate 201. A portion of the active region may have source/drain regions 205 including impurities disposed therein. The substrate 201 may include a semiconductor material, such as a group IV semiconductor, a group III-V compound semiconductor, and/or a group II-VI compound semiconductor. The substrate 201 may be provided as a bulk wafer or an epitaxial layer.

The circuit devices 220 may include a planar transistor. Each circuit device 220 may include a circuit gate dielectric layer 222, a spacer layer 224, and a circuit gate electrode 225. Source/drain regions 205 may be disposed as source/drain regions in the substrate 201 on both sides (e.g., opposite sides) of the circuit gate electrode 225.

The peripheral region insulating layer 290 may be disposed on (to cover or overlap) the circuit devices 220 on an upper surface of the substrate 201. The peripheral region insulating layer 290 may include a plurality of insulating layers formed by different processes. The peripheral region insulating layer 290 may include (e.g., may be formed of) an insulating material. A portion of the peripheral region insulating layer 290 may function as a second bonding insulating layer 299.

Circuit contact plugs 270 and circuit interconnection lines 280 may form a circuit interconnection structure electrically connected to the circuit devices 220 and the source/drain regions 205. The circuit contact plugs 270 may have a cylindrical shape, and the circuit interconnection lines 280 may have a line shape. An electrical signal may be applied to the circuit device 220 by the circuit contact plugs 270 and the circuit interconnection lines 280. In a region not illustrated, the circuit contact plugs 270 may also be (electrically) connected to the circuit gate electrode 225. The circuit interconnection lines 280 may be (electrically) connected to the circuit contact plugs 270 and may be disposed in a plurality of layers. The circuit contact plugs 270 and the circuit interconnection lines 280 may include a conductive material, for example, tungsten (W), copper (Cu), aluminum (Al), or the like, and each component may further include a diffusion barrier. In example embodiments, the number of layers of the circuit contact plugs 270 and the circuit interconnection lines 280 may be varied.

The second bonding vias 295, the second bonding metal layers 298, and the second bonding insulating layer 299, included in the second semiconductor structure S2, may be disposed on a portion of the uppermost portion of the circuit interconnection lines 280. The second bonding vias 295 may have a cylindrical shape, and the second bonding metal layers 298 may have a pad shape having a circular shape or a relatively short line shape on a plane. The upper surfaces of the second bonding metal layers 298 may be exposed to an upper surface of the second semiconductor structure S2. The second bonding vias 295 and the second bonding metal layers 298 may provide electrical connection paths with the first semiconductor structure S1. In example embodiments, a portion of the second bonding metal layers 298 may be disposed solely for bonding without being (electrically) connected to the circuit interconnection lines 280. The second bonding vias 295 and the second bonding metal layers 298 may include a conductive material, for example, copper (Cu).

The second bonding insulating layer 299 may be defined to have a predetermined thickness from the upper surface of the peripheral region insulating layer 290, but may also be implemented as another insulating layer on the upper surface of the peripheral region insulating layer 290. The second bonding insulating layer 299 may be provided for dielectric-dielectric bonding with the first bonding insulating layer 199 of the first semiconductor structure S1. The second bonding insulating layer 299 may also function as a diffusion barrier for the second bonding metal layers 298, and may include, for example, SiO, SiN, SiCN, SiOC, SiON, and/or SiOCN.

The first and second semiconductor structures S1 and S2 may be bonded to each other by bonding between the first bonding metal layers 198 and the second bonding metal layers 298 and by bonding between the first bonding insulating layer 199 and the second bonding insulating layer 299. The bonding between the first bonding metal layers 198 and the second bonding metal layers 298 may be, for example, metal-metal bonding, such as copper (Cu)-copper (Cu) bonding, and the bonding between the first bonding insulating layer 199 and the second bonding insulating layer 299 may be, for example, dielectric-dielectric bonding, such as SiCN-SiCN bonding. The first and second semiconductor structures S1 and S2 may be bonded to each other by hybrid bonding including metal-metal bonding and dielectric-dielectric bonding.

The first and second semiconductor structures S1 and S2 may be packaged in a form in which the first semiconductor structure S1 may be positioned in an upper portion as illustrated in FIG. 9. In some embodiments, the first and second semiconductor structures S1 and S2 may be packaged upside down in a form in which the second semiconductor structure S2 may be positioned in an upper portion.

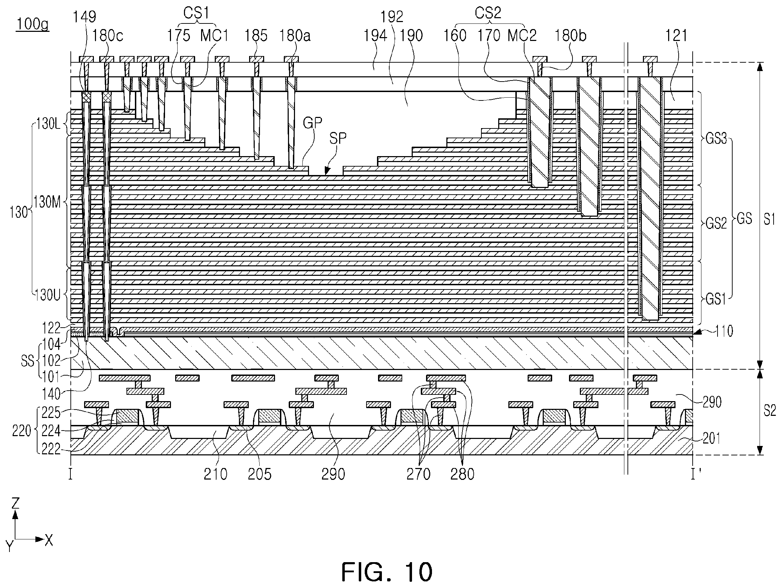

Referring to FIG. 10, a semiconductor device 100g may include a first semiconductor structure S1 and a second semiconductor structure S2 below the first semiconductor structure S1. The first semiconductor structure S1 may include a memory cell region, and the second semiconductor structure S2 may include a peripheral circuit region. In some example embodiments, the second semiconductor structure S2 may be disposed on the first semiconductor structure S1.

As for the first semiconductor structure S1, the description described with reference to FIGS. 1, 2A, 2B, 3A, 3B, and 3C may be applied. However, the first semiconductor structure S1 may further include first and second horizontal conductive layers 102 and 104, a horizontal insulating layer 110, and a substrate insulating layer 122.

The first and second horizontal conductive layers 102 and 104 may be stacked in order and may be disposed on the upper surface of the conductive layer 101 in the first region R1. The first and second horizontal conductive layers 102 and 104 may form a common source structure with the conductive layer 101 and may function as a common source line of the semiconductor device 100g. The first horizontal conductive layer 102 may be directly connected to the channel layer 140 in a lower portion of the channel structures CH. The first and second horizontal conductive layers 102 and 104 may include a semiconductor material, for example, polycrystalline silicon. In this case, at least the first horizontal conductive layer 102 may be doped with impurities having the same conductivity as that of the conductive layer 101.

The horizontal insulating layer 110 may be disposed on the conductive layer 101 at the same level as the first horizontal conductive layer 102 in at least a portion of the upper contact region R3 and the extension region R2. The horizontal insulating layer 110 may include first and second horizontal insulating layers alternately stacked on the conductive layer 101. The horizontal insulating layer 110 may be layers remaining after a portion thereof is replaced with the first horizontal conductive layer 102 in a process of manufacturing the semiconductor device 100g. The horizontal insulating layer 110 may include, for example, silicon oxide, silicon nitride, silicon carbide, and/or silicon oxynitride. The first horizontal insulating layers and the second horizontal insulating layer may include different insulating materials.

The substrate insulating layer 122 may be disposed to overlap (e.g., cover) a bent portion of the second horizontal conductive layer 104 between the memory region R1 and the upper contact region R3. In some example embodiments, when a penetrating electrode extending from the first semiconductor structure S1 to the second semiconductor structure S2 is included, the substrate insulating layer 122 may penetrate the conductive layer 101, the horizontal insulating layer 110, and the second horizontal conductive layer 104, and the penetrating electrode may penetrate the substrate insulating layer 122. The substrate insulating layer 122 may include an insulating material, for example, silicon oxide, silicon nitride, silicon carbide, and/or silicon oxynitride.

The configuration of the second semiconductor structure S2 in FIG. 10 may be the same as that of the second semiconductor structure S2 in FIG. 9, but the second semiconductor structure S2 may have a structure in which the conductive layer 101 may be formed directly on the peripheral region insulating layer 290 without including a bonding structure in an upper portion. In addition, relative to the arrangement of FIG. 9, the first semiconductor structure S1 may be flipped (e.g. may be in the same orientation as in FIG. 2).

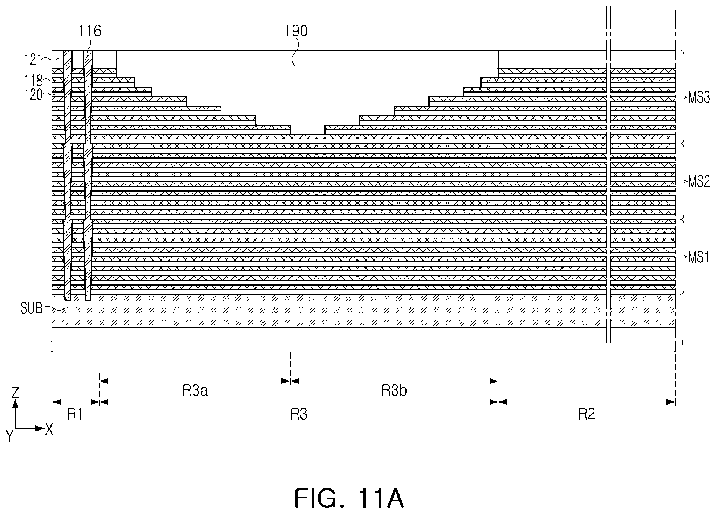

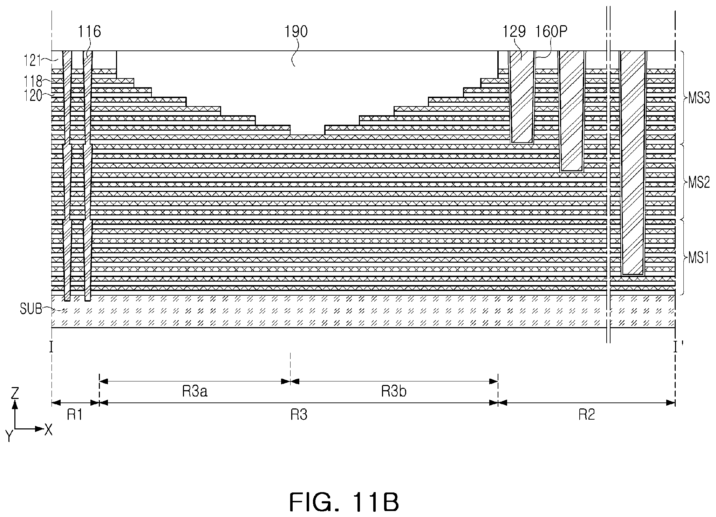

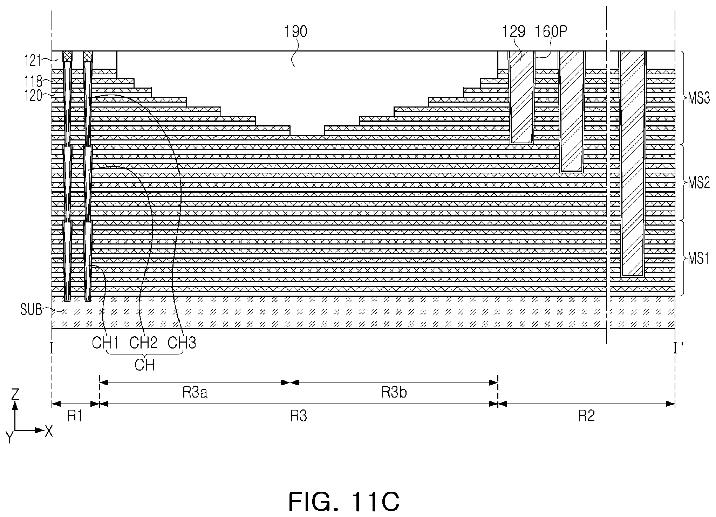

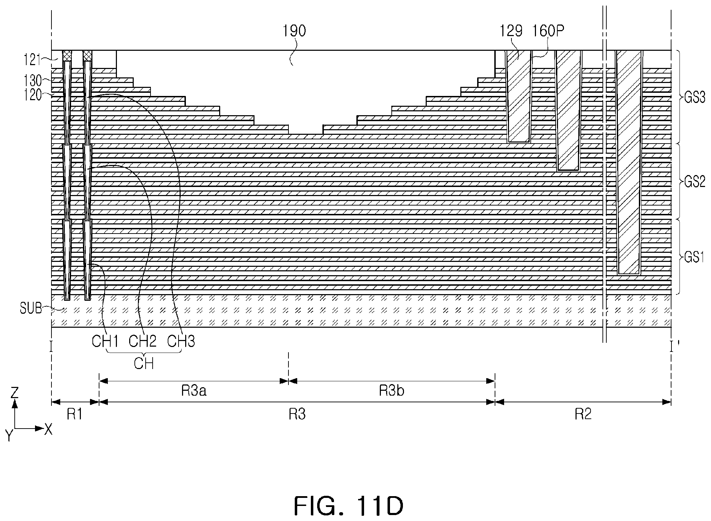

FIGS. 11A, 11B, 11C, and 11D are cross-sectional views illustrating a method of manufacturing a semiconductor device according to an example embodiment, illustrating cross-sectional surfaces corresponding to FIG. 2A.

Referring to FIG. 11A, sacrificial insulating layers 118 and interlayer insulating layers 120 may be alternately stacked on a base substrate SUB, and may be formed up to an uppermost interlayer insulating layer 121. Vertical sacrificial structures 116 extending into (e.g., penetrating) mold structures MS (e.g., mold structures MS1-MS3) may be formed, and a cell region insulating layer 190 may be formed.

The base substrate SUB may be a semiconductor substrate, such as a silicon (Si) wafer, and may be removed through a subsequent process. The first mold structure MS1 of the mold structure MS1-MS3 may be preferentially formed, and high aspect ratio contact (HARC) etching to penetrate the structure may be performed, a portion of the vertical sacrificial structures 116 may be formed, the second mold structure MS2 may be formed, HARC etching to extend into (e.g., penetrate) the structure may be performed, and a portion of the vertical sacrificial structures 116 may be formed. In (substantially) the same manner, a portion of the third mold structure MS3 and the vertical sacrificial structures 116 may be formed.

The sacrificial insulating layers 118 may be replaced with gate electrodes 130 (see FIG. 2A) through a subsequent process (or a series of subsequent processes). The sacrificial insulating layers 118 may include (e.g., may be formed of) a material different from that of the interlayer insulating layers 120, and may include (e.g., may be formed of) a material with etch selectivity under specific etching conditions with respect to the interlayer insulating layers 120. For example, the interlayer insulating layer 120 may include (e.g., may be formed of) silicon oxide and/or silicon nitride, and the sacrificial insulating layers 118 may include (e.g., may be formed of) a material other than a material of the interlayer insulating layer 120, such as silicon, silicon oxide, silicon carbide, and/or silicon nitride. In example embodiments, thicknesses of the interlayer insulating layers 120 may not be the same, and the uppermost interlayer insulating layer 121 may have a thickness greater than that of the other interlayer insulating layers 120. The thicknesses of the interlayer insulating layers 120 and the sacrificial insulating layers 118 and the number of films included therein may be varied from the illustrated examples.

The vertical sacrificial structures 116 may be formed in positions corresponding to the channel structures CH, the dummy channel structures DH, and the support structures SH in FIG. 2A. The vertical sacrificial structures 116 may be formed, for example, to have the same size as those of the channel structures CH, the dummy channel structures DH, and the support structures SH. The vertical sacrificial structures 116 may include, for example, carbon (C), but an example embodiment thereof is not limited thereto.

When the third mold structure MS3 is formed, staircase-form etching for a step difference structure of a staircase shape corresponding to the first upper contact region R3a and the second upper contact region R3b may be performed in the upper contact region R3. Accordingly, the uppermost interlayer insulating layer 121 to the sacrificial insulating layer 118 corresponding to the seventh gate electrode (e.g., 130U1 in FIG. 2A) may be etched in order and a staircase shape may be formed.

When the step difference structure of the staircase shape is formed, the cell region insulating layer 190 may be formed on the staircase shape. In some embodiments, the upper surface of the cell region insulating layer 190 may be coplanar with the upper surface of the uppermost interlayer insulating layer 121.

Referring to FIG. 11B, a mask layer may be formed on the uppermost interlayer insulating layer 121, and accordingly, the contact sacrificial structures 129 for forming wordline contact plugs MC2 may be formed.

Specifically, contact holes for reaching the allocated gate electrode (the corresponding sacrificial insulating layer 118) of each wordline contact plug MC2 may be formed through multiple etchings. As for the formation of the contact holes, the number of etchings and the etching order may be applied differently depending on levels of allocated gate electrodes 130.

For example, when the total number of layers of the entire gate electrodes 130 is defined as N, and is converted to binary, contact etching may be performed as many times as the number of binary digits. The contact etching may be performed at different depths depending on the number of the converted binary digits. For example, in the contact etching corresponding to the first digit, the sacrificial insulating layer 118 and the interlayer insulating layer 120 corresponding to one gate electrode (2⁰) may be etched, and in the contact etching corresponding to the second digit, the sacrificial insulating layers 118 and the interlayer insulating layers 120 corresponding to two gate electrodes (2¹) may be etched simultaneously. In the contact etching corresponding to the third digit, the sacrificial insulating layers 118 and the interlayer insulating layers 120 corresponding to four gate electrodes (2²) may be etched, and in the contact etching corresponding to the fourth digit, the sacrificial insulating layers 118 and the interlayer insulating layers 120 corresponding to eight gate electrodes (2³) may be etched, and in the contact etching corresponding to the fifth digit, the sacrificial insulating layers 118 and the interlayer insulating layers 120 corresponding to 16 gate electrodes (2⁴) may be etched. The number of layers of each gate electrode 130 allocated may be converted into a binary number, and contact etching corresponding to the number of digits having 1 in the converted binary number may be applied, such that contact holes may be formed at different depths.

Accordingly, by applying contact etching corresponding to the number of digits of the binary number differently to the contact holes, etching may only be performed a number of times corresponding to the number of digits in binary, and contact holes having different depths, which may open each of the gate electrodes 130 having a relatively large number of layers, may be formed.

As illustrated in FIG. 11B, preliminary contact insulating layers 160P and contact sacrificial layers 129 may be formed in each contact hole.

The preliminary contact insulating layers 160P may be conformally formed to cover sidewalls and a lower surface (e.g., a bottom surface) of each of the contact holes. For example, the preliminary contact insulating layers 160P may be formed using a chemical vapor deposition (CVD) process.

The contact sacrificial layers 129 may be formed to fill each contact hole on the preliminary contact insulating layers 160P. The contact sacrificial layers 129 may include a material different from the preliminary contact insulating layers 160P, and may include carbon (C), for example. Upper ends of the contact sacrificial layers 129 and the preliminary contact insulating layers 160P may be formed to be coplanar with the uppermost interlayer insulating layer 121.

Referring to FIG. 11C, a portion of the vertical sacrificial structures 116 may be removed and channel structures CH and dummy channel structures DH may be formed.

A mask layer exposing only a region corresponding to the channel structures CH and a region corresponding to dummy channel structures DH in the memory region R1 and in the upper contact region R3 may be formed, and channel holes may be formed by removing the exposed vertical sacrificial structures 116. At least a portion of the channel dielectric layer 145, the channel layer 140, the buried insulating layer 147, and the channel pad 149 may be deposited in order in the channel holes, thereby forming the channel structures CH and/or the dummy channel structures DH.

The channel dielectric layer 145 may be formed to have a uniform thickness using an ALD and/or CVD process. In this process, the channel dielectric layer 145 may be formed entirely or partially, and a portion extending vertically along the channel structures CH to the conductive layer 101 may be formed in this process. The channel layer 140 may be formed on the channel dielectric layer 145 in the channel holes. The buried insulating layer 147 may be formed to fill the channel holes and may include (may be) an insulating material. The channel pad 149 may include (e.g., may be formed of) a conductive material, for example, the channel pad 149 may include (e.g., may be formed of) polycrystalline silicon.

Also, a portion of the vertical sacrificial structures 116 may be removed and preliminary support structures may be formed.

A mask layer exposing a region corresponding to the support structures SH in the upper contact region R3 and the extension region R2 may be formed, and dummy holes may be formed by removing the exposed vertical sacrificial structures 116. A process of expanding the dummy holes by removing a portion of the mold structure MS around the dummy holes may be performed. The support structures SH may be formed by filling the expanded dummy holes with an insulating material.

Referring to FIG. 11D, the sacrificial insulating layers 118 may be removed and the gate electrodes 130 may be formed.

An isolation opening for opening a region corresponding to the isolation regions MS in FIGS. 1 and 2B may be formed. The isolation opening may be formed by forming a plurality of vertical holes in the region in which the isolation regions MS are formed, expanding the plurality of vertical holes through a cleaning process, and connecting the holes with the neighboring vertical holes. When the isolation opening is formed by expanding the plurality of vertical holes, the side surface of the isolation opening may include convex surfaces continuously, but an example embodiment thereof is not limited thereto.

The sacrificial insulating layers 118 exposed through the isolation openings may be removed. The sacrificial insulating layers 118 may be selectively removed, for example, using wet etching, with respect to the interlayer insulating layers 120, the channel structures CH, the dummy channel structures DH, the support structures SH, and the preliminary contact insulating layers 160P.

The gate electrodes 130 may be formed by depositing a conductive material on regions from which the sacrificial insulating layers 118 have been removed. The conductive material may include, for example, a metal, polycrystalline silicon, and/or a metal silicide material. The diffusion barriers 132 (see FIG. 3A) may be formed in the gate electrodes 130, and the gate electrodes 130 may be formed by depositing the conductive material layer 135. In some example embodiments, a portion of the channel dielectric layer 145 may be formed prior to forming the gate electrodes 130. Accordingly, a stack structure GS including first to third stack structures GS1-GS3 may be formed. After the gate electrodes 130 are formed, isolation regions MS extending in the first horizontal direction (e.g., the X-direction) as illustrated in FIG. 1 may be formed by depositing an insulating material in the isolation openings.

In this case, insulating regions SS extending into (e.g., penetrating) the upper gate electrodes 130U may be formed. As illustrated in FIG. 1 and FIG. 2B, trenches for removing the upper gate electrodes 130U and the interlayer insulating layer 120 in the region corresponding to the insulating regions SS may be formed.

Between two adjacent isolation regions MS, trenches corresponding to the insulating regions SS may be formed to selectively cut an upper portion of the third stack structure GS3 by penetrating the first to seventh upper gate electrodes 130U1-130U7 from an upper portion of the uppermost interlayer insulating layer 121 so as to extend in the first horizontal direction (e.g., the X-direction) in the memory region R1 and the upper contact region R3. The trenches may be formed in a wavy shape to extend while cutting a portion of the channel structures CH in the memory region R1, and may extend in a line shape in the upper contact region R3.

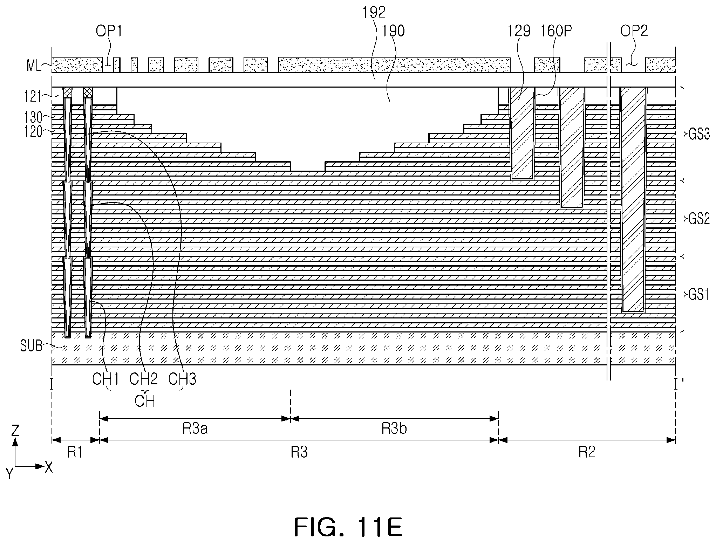

As illustrated in FIG. 11E, the first upper insulating layer 192 may be formed, and first and second openings OP1 and OP2 may be formed in a mask layer ML on the first upper insulating layer 192.

First, the first upper insulating layer 192 may be formed by overlapping (e.g., covering) the upper surface of the uppermost interlayer insulating layer 121 and the cell region insulating layer 190. The first upper insulating layer 192 may be formed by depositing a first thickness t1, and may include (e.g., may be formed of) an insulating material such as an oxide and/or a nitride.

A mask layer ML may be formed on the first upper insulating layer 192, the mask layer ML may be patterned by a photolithography process such that a first opening OP1 may be formed in a region corresponding to the upper contact plugs MC1, and a second opening OP2 may be formed in a region corresponding to the wordline contact plugs MC2.

A width of the second opening OP2 may be greater than a width of the first opening OP1, and a width of the second opening OP2 may be the same as a width including the upper surface width W4 of the wordline contact plug MC2 and a thickness ta of the second side-surface insulating layer 170 extending around (e.g., surrounding) the wordline contact plug MC2. A width of the first opening OP1 may be the same as a sum of a width W1 of the upper surface of the upper contact plug MC1 and the thickness ta of the upper side-surface insulating layer 175 extending around (e.g., surrounding) the same. For example, the width of the second opening OP2 may be approximately 400 nm, and the width of the first opening OP1 may be approximately 200 nm, but an example embodiment thereof is not limited thereto.

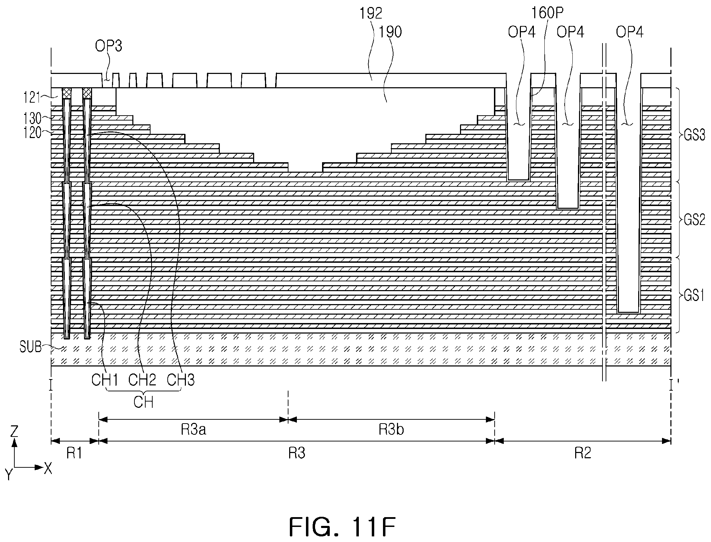

As in FIG. 11F, the first upper insulating layer 192 may be etched using the first opening OP1 and the second opening OP2, thereby forming third openings OP3 and fourth openings OP4, respectively.

The third openings OP3 may expose an upper surface of the cell region insulating layer 190 in the lower portion or an upper surface of the uppermost interlayer insulating layer 121 by removing the first upper insulating layer 192 through the first openings OP1.

The fourth openings OP4 may be formed by etching the first upper insulating layer 192 through the second openings OP2 and selectively removing the contact sacrificial layers 129 in the lower portion with respect to the preliminary contact insulating layers 160P. Accordingly, a side surface and a lower surface (e.g., a bottom surface) of the preliminary contact insulating layers 160P may be exposed to the fourth openings OP4.

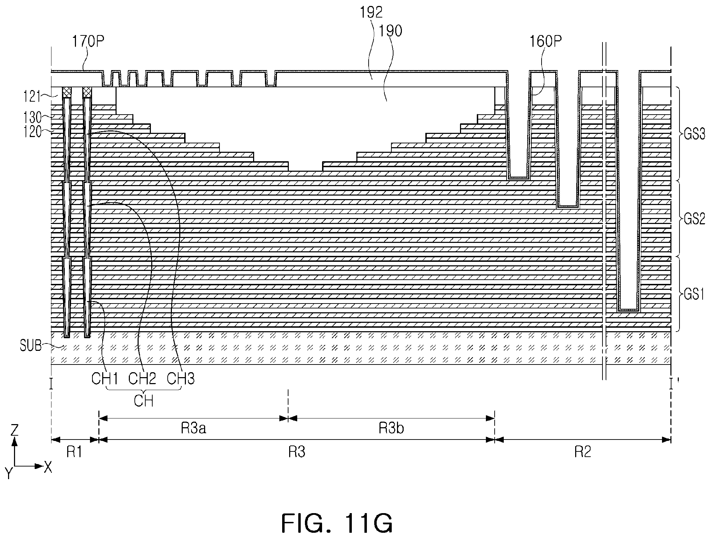

Referring to FIG. 11G, a preliminary side-surface insulating layer 170P may be formed along the third opening OP3 and the fourth opening OP4. The preliminary side-surface insulating layers 170P may be uniformly formed to have a thickness of (about) 400 Å to (about) 500Å through atomic layer deposition (ALD).

The preliminary side-surface insulating layers 170P may include (e.g., may be formed of) silicon oxide, silicon nitride, or the like, but an example embodiment thereof is not limited thereto, and various insulating materials which may be used in atomic layer deposition may be applied. By the atomic layer deposition, an insulating layer may be formed to have a greater thickness on the preliminary contact insulating layers 160P in the fourth opening OP4, and an insulating layer may also be formed on a side surface and a lower surface (e.g., a bottom surface) of the third opening OP3.

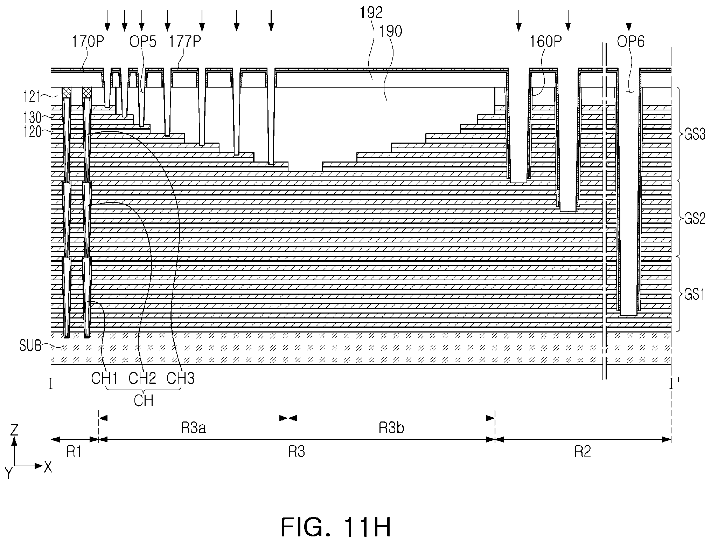

Referring to FIG. 11H, by performing an etch back process, the lower surfaces (e.g., the bottom surfaces) of the exposed preliminary side-surface insulating layer 170P and the exposed preliminary contact insulating layers 160P of the fourth opening OP4 may be removed, and the uppermost interlayer insulating layer 121 or the cell region insulating layers 190 may be removed through the lower surfaces (e.g., the bottom surfaces) of the preliminary side-surface insulating layers 170P of the third opening OP3.

Accordingly, the pad region GP of the upper gate electrode 130U allocated to the lower surface (e.g., the bottom surface) of the third opening OP3 may be exposed, and the contact region of the memory gate electrode 130M or the lower gate electrode 130L allocated to the lower surface (e.g., the bottom surface) of the fourth opening OP4 may be exposed. In the etch-back process, the gate electrodes 130 may function as etch stoppers, and anisotropic etching may be performed in the vertical direction through dry etching, such that the cell region insulating layer 190 therebelow may be etched through the third opening OP3 such that contact holes OP5 exposing the upper gate electrodes 130U may be formed, and by removing the lower surface (e.g., the bottom surface) of the exposed preliminary side-surface insulating layer 170P and the exposed preliminary contact insulating layers 160P of the fourth opening OP4, contact holes OP6 may be formed.

In this case, a blocking layer 177P may be further formed on an upper portion of the preliminary side-surface insulating layer 170P, specifically, on an upper surface of the preliminary side-surface insulating layer 170P on the first upper insulating layer 192 horizontal to the base substrate SUB, and when the blocking layer 177P is formed as above, the preliminary side-surface insulating layer 170P in an upper region of the preliminary side-surface insulating layer 170P, that is, an upper region of the contact holes OP5 and OP6, may be prevented from being partially lost in the etch-back process.

The blocking layer 177P may be formed by a polymer blocking process in a dry etching process facility, a portion thereof may be lost by the etch-back process, and the remaining blocking layer 177P may be removed by an ashing and strip process.

When the blocking layer 177P is a nitride film formed by a process other than the polymer blocking process in the dry etching process facility, the layer may remain as in FIG. 7 and may be disposed as the blocking insulating layer 177, but an example embodiment thereof is not limited thereto.

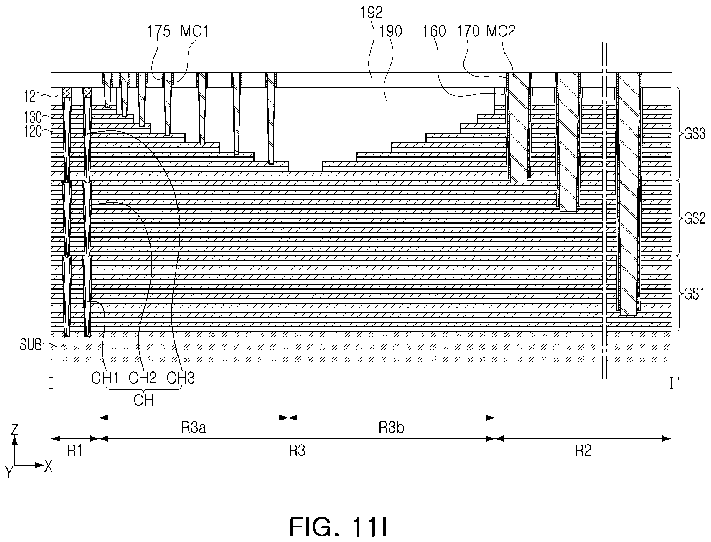

Referring to FIG. 11I, by filling the contact holes OP5 and OP6 and depositing a conductive material, contact plugs MC1 and MC2 may be formed. The contact plugs MC1 and MC2 may be physically connected to gate electrodes 130 allocated therebelow, respectively. When the contact holes OP5 and OP6 are entirely filled, by performing a planarization process, the conductive material and the preliminary side-surface insulating layer 170P may be etched until the upper surface of the first upper insulating layer 192 is exposed.

In this case, the planarization process may be performed through chemical mechanical polishing (CMP), and accordingly, the upper surface of the first upper insulating layer 192 and the upper surface of the contact plugs MC1 and MC2, (the upper end of) the upper side-surface insulating layer 175, and the upper end of the second side-surface insulating layer 170 may be coplanar with each other.

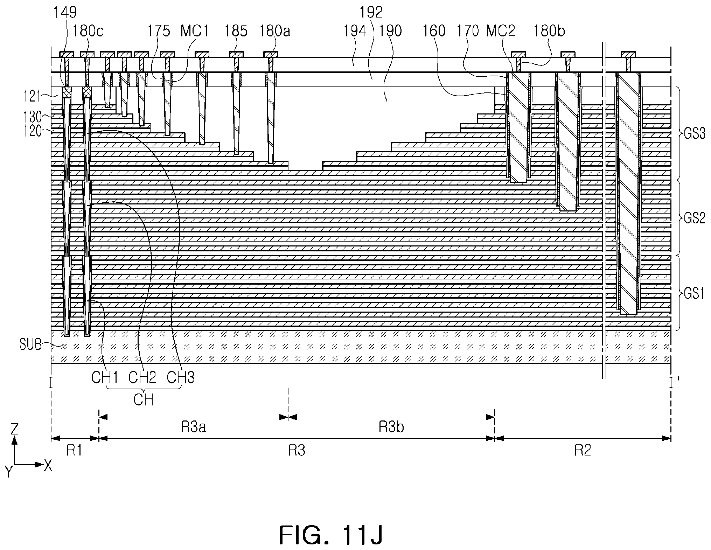

Referring to FIG. 11J, an upper interconnection structure may be formed on the stack structure GS.

A second upper insulating layer 194 may be formed on the first upper insulating layer 192, studs 180a, 180b, and 180c and cell interconnection lines 185 may be formed.

The first and second studs 180a and 180b may be formed by stud holes extending into (e.g., penetrating) the second upper insulating layer 194 and exposing the contact plugs MC1 and MC2, and filling the stud holes with a conductive material. The third studs 180c may be formed by stud holes extending into (e.g., penetrating) the first and second upper insulating layers 192 and 194 and exposing the channel structures CH, and filling the stud holes with a conductive material. The cell interconnection lines 185 may be formed on the studs 180a, 180b, and 180c. An insulating layer may be further formed on the cell interconnection lines 185, and a bonding structure for bonding with the second semiconductor structure (e.g., the second semiconductor structure S2) in FIG. 9 may also be formed.

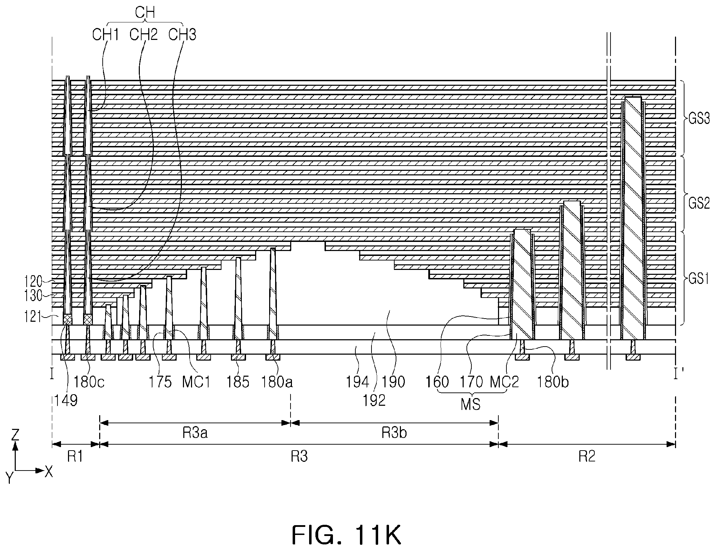

Referring to FIG. 11K, the base substrate SUB may be removed, and the channel layers 140 may be exposed.

By removing the base substrate SUB and a portion of the exposed channel dielectric layers 145 (see FIG. 3A), the channel layers 140 may be exposed.

Thereafter, referring to FIG. 2A, a conductive layer 101 connected to the channel layers 140 may be formed, and the semiconductor device 100 in FIG. 2A may be manufactured. In some example embodiments, the conductive layer 101 may be formed as a conformal layer along upper ends of the channel structures CH (illustrated in FIG. 11K) and upper ends of the dummy channel structures DH (illustrated in FIG. 11K).

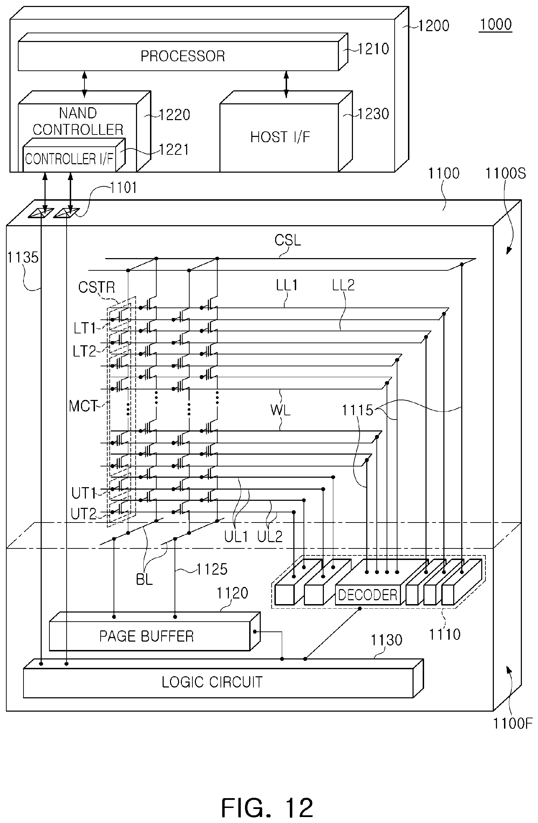

FIG. 12 is a view illustrating a data storage system including a semiconductor device according to an example embodiment.

Referring to FIG. 12, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, and/or a communication device.

The semiconductor device 1100 may be implemented as a non-volatile memory device, such as, for example, the NAND flash memory device described in the aforementioned example embodiment with reference to FIGS. 1 to 10. The semiconductor device 1100 may include a first structure 1100F and a second structure 1100S on the first structure 1100F. In the example embodiments, the first structure 1100F may be disposed on the side of the second structure 1100S. The first structure 1100F may be implemented as a peripheral circuit structure including a decoder circuit 1110, a page buffer 1120, and a logic circuit 1130. The second structure 1100S may be implemented as a memory cell structure including a bitline BL, a common source line CSL, wordlines WL, first and second gate upper lines UL1 and UL2, first and second gate lower lines LL1 and LL2 and memory cell strings CSTR disposed between the bitline BL and the common source line CSL.

In the second structure 1100S, each of the memory cell strings CSTR may include lower transistors LT1 and LT2 adjacent to the common source line CSL, upper transistors UT1 and UT2 adjacent to the bitline BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in the example embodiments.

In the example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The wordlines WL may be configured as gate electrodes of the memory cell transistors MCT, and the gate upper lines UL1 and UL2 may be configured as gate electrodes of the upper transistors UT1 and UT2, respectively.

In the example embodiments, the lower transistors LT1 and LT2 may include a lower erase control transistor LT1 and a ground select transistor LT2 (electrically) connected to each other in series. The upper transistors UT1 and UT2 may include a string select transistor UT1 and an upper erase control transistor UT2 (electrically) connected to each other in series. At least one of the lower erase control transistor LT1 and the upper erase control transistor UT2 may be used in an erase operation for erasing data stored in the memory cell transistors MCT using a gate-induced drain leakage (GIDL) phenomenon.

The common source line CSL, the first and second gate lower lines LL1 and LL2, the wordlines WL, and the first and second gate upper lines UL1 and UL2 may be electrically connected to the decoder circuit 1110 through first connection interconnections 1115 extending from the first structure 1100F to the second structure 1100S. The bitlines BL may be electrically connected to the page buffer 1120 through second connection interconnections 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command. As used hereinafter, the terms "external/outside configuration", "external/outside device", "external/outside power", "external/outside signal", or "outside" are intended to broadly refer to a device, circuit, block, module, power, and/or signal that resides externally (e.g., outside of a functional or physical boundary) with respect to a given circuit, block, module, system, or device.

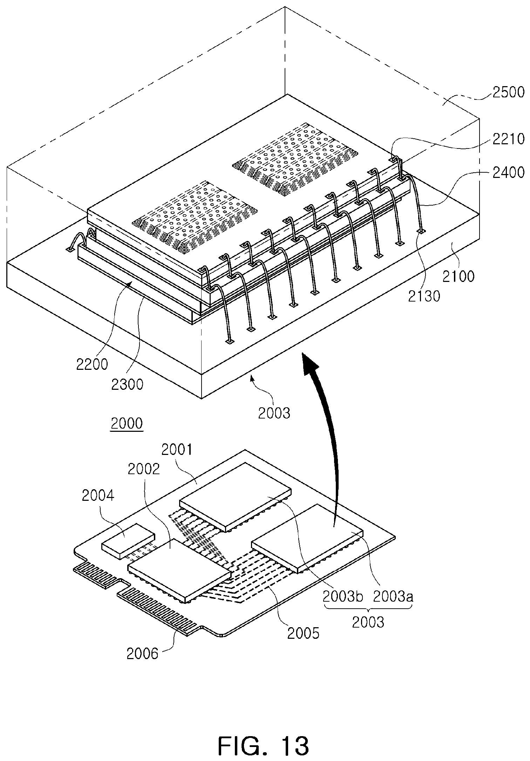

FIG. 13 is a perspective view illustrating a data storage system including a semiconductor device according to an example embodiment.

Referring to FIG. 13, a data storage system 2000 in an example embodiment may include a main board 2001, a controller 2002 mounted on the main board 2001, one or more semiconductor packages 2003, and a DRAM 2004. The semiconductor package 2003 and the DRAM 2004 may be (electrically) connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In the example embodiments, the data storage system 2000 may communicate with an external host according to, for example, universal serial bus (USB), peripheral component interconnect express (PCI-Express), serial advanced technology attachment (SATA), and/or M-Phy for universal flash storage (UFS). In the example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 on (e.g., covering or overlapping) the semiconductor chips 2200 and the connection structure 2400 on the package substrate 2100.

The package substrate 2100 may be configured as a printed circuit board including upper pads 2130. Each semiconductor chip 2200 may include an input/output pad 2210. The input/output pad 2210 may correspond to the input/output pad 1101 in FIG. 12. Each of the semiconductor chips 2200 may include stack structures GS and channel structures CH. Each of the semiconductor chips 2200 may include the semiconductor device described in the aforementioned example embodiment with reference to FIGS. 1 to 10.

In the example embodiments, the connection structure 2400 may be configured as a bonding wire electrically connecting the input/output pad 2210 to the upper pads 2130. Accordingly, in each of the first and second semiconductor packages 2003a and 2003b, the semiconductor chips 2200 may be electrically connected to each other by a bonding wire method, and may be electrically connected to the upper pads 2130 of the package substrate 2100. In the example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the example embodiments, the controller 2002 and the semiconductor chips 2200 may be included in a single package. In an example embodiment, the controller 2002 and the semiconductor chips 2200 may be mounted on an interposer substrate different from the main board 2001, and the controller 2002 and the semiconductor chips 2200 may be (electrically) connected to each other by interconnection formed on the interposer substrate.

According to the aforementioned example embodiments, as the upper gate electrodes include string select electrodes, the string select contact plugs may be formed simultaneously with the wordline select plugs on the pad region of each of the exposed string select gate electrodes while a step difference structure of a staircase shape is formed on the string select electrodes. Also, the studs disposed on the upper portion may be formed simultaneously with the string select contact plugs on the wordline select plugs. Accordingly, studs for the string select contact plugs may not be separately formed, such that the process may be simplified.

Embodiments are set out in the following Clauses:
1. A semiconductor device, comprising:
   a conductive layer;
   a stack structure on the conductive layer, wherein the stack structure includes a first region, a second region, and a third region that is between the first region and the second region in a first direction that is parallel with an upper surface of the conductive layer, wherein the stack structure includes memory gate electrodes and upper gate electrodes that are stacked and spaced apart from each other in a second direction that is perpendicular to the upper surface of the conductive layer, and wherein ones of the upper gate electrodes extend to different lengths in the first direction in the third region and the ones of the upper gate electrodes include pad regions, respectively;
   an insulating layer on the stack structure;
   isolation regions that extend into the upper gate electrodes in the first direction in the first region and the third region;
   a channel structure that extends into the stack structure in the second direction in the first region;
   first contact structures that extend into the insulating layer in the second direction, wherein the first contact structures are electrically connected to the pad regions of the ones of the upper gate electrodes, respectively, in the third region;
   second contact structures that extend into the upper gate electrodes, the insulating layer, and at least one of the memory gate electrodes, wherein the second contact structures are electrically connected to the memory gate electrodes, respectively, in the second region, and wherein respective upper surfaces of the second contact structures are coplanar with respective upper surfaces of the first contact structures;
   first studs on the first contact structures; and
   second studs on the second contact structures,
   wherein respective upper surfaces of the first studs are coplanar with respective upper surfaces of the second studs, and
   wherein respective lower surfaces of the first studs are coplanar with respective lower surfaces of the second studs.
2. The semiconductor device of Clause 1, wherein each of the first contact structures includes:
   a first contact plug, wherein an upper surface of the first contact plug is coplanar with an upper surface of the insulating layer, a lower surface of the first contact plug is in contact with one of the pad regions of the upper gate electrodes, and a side surface of the first contact plug is between the upper surface of the first contact plug and the lower surface of the first contact plug; and
   an upper side-surface insulating layer that extends around the side surface of the first contact plug.
3. The semiconductor device of Clause 2, wherein each of the second contact structures includes:
   a second contact plug, wherein an upper surface of the second contact plug is coplanar with the upper surface of the first contact plug, a lower surface of the second contact plug is in contact with one of the memory gate electrodes, and a side surface of the second contact plug is between the upper surface of the second contact plug and the lower surface of the second contact plug;
   a first side-surface insulating layer between the second contact plug and the stack structure, wherein the first side-surface insulating layer extends around the side surface of the second contact plug; and
   a second side-surface insulating layer between the first side-surface insulating layer and the second contact plug.
4. The semiconductor device of Clause 3, wherein the upper side-surface insulating layer and the second side-surface insulating layer include a same material, and
   wherein an upper end of the upper side-surface insulating layer is coplanar with an upper end of the second side-surface insulating layer.
5. The semiconductor device of any preceding Clause, wherein a diameter of at least one of the respective upper surfaces of the first contact structures is less than a diameter of at least one of the upper surfaces of the second contact structures.
6. The semiconductor device of any preceding Clause, wherein a diameter of at least one of the respective upper surfaces of the first studs is equal to a diameter of at least one of the respective upper surfaces of the second studs, and
   wherein the first studs and the second studs include a same material.
7. A data storage system, comprising:
   a semiconductor storage device that includes a first semiconductor structure that includes circuit devices, a second semiconductor structure on the first semiconductor structure, and an input/output pad that is electrically connected to the circuit devices; and
   a controller that is electrically connected to the semiconductor storage device through the input/output pad, wherein the controller is configured to control the semiconductor storage device,
   wherein the second semiconductor structure comprises:
      a conductive layer;
      a stack structure on the conductive layer, wherein the stack structure includes a first region, a second region, and a third region that is between the first region and the second region in a first direction that is parallel with an upper surface of the conductive layer, wherein the stack structure includes lower gate electrodes, memory gate electrodes, and upper gate electrodes that are stacked and spaced apart from each other in a second direction that is perpendicular to the upper surface of the conductive layer, and wherein ones of the upper gate electrodes extend to different lengths from one another in the first direction in the third region and include pad regions;
      an insulating layer on the stack structure;
      a channel structure that extends into the stack structure in the second direction in the first region;
      first contact plugs that extend into the insulating layer in the second direction, wherein the first contact plugs are electrically connected to the pad regions of the upper gate electrodes, respectively, in the third region;
      second contact plugs that extend into at least one among the upper gate electrodes, the memory gate electrodes, and the lower gate electrodes and the insulating layer in the second direction, wherein ones of the second contact plugs extend to different lengths from one another in the second direction and are electrically connected to the lower gate electrodes and/or the memory gate electrodes, respectively, in the second region;
      a side-surface insulating structure that extends around a side surface of each of the second contact plugs in the second region; and
   an upper side-surface insulating layer that extends around a side surface of each of the first contact plugs in the third region.

While the example embodiments have been illustrated and described above, it will be configured as apparent to those skilled in the art that modifications and variations could be made without departing from the scope of the present disclosure as defined by the appended claims.

## Claims

1. A semiconductor device, comprising:
a conductive layer (101);
a stack structure on the conductive layer (101), wherein the stack structure includes a first region, a second region, and a third region that is between the first region and the second region in a first direction that is parallel with an upper surface of the conductive layer (101), wherein the stack structure further includes lower gate electrodes (130L), memory gate electrodes (130M), and upper gate electrodes (130U), that are stacked and spaced apart from each other in a second direction that is perpendicular to the upper surface of the conductive layer (101), and wherein ones of the upper gate electrodes (130U) extend to different lengths from one another in the first direction in the third region and the ones of the upper gate electrodes (130U) include pad regions (GP), respectively;
an insulating layer (192) on the stack structure;
a channel structure (CH) that extends into the stack structure in the second direction in the first region;
first contact plugs (MC1) that extend into the insulating layer (192) in the second direction, wherein the first contact plugs are electrically connected to the pad regions (PG) of the ones of the upper gate electrodes (130U), respectively, in the third region;
second contact plugs (MC2) that extend into at least one among the upper gate electrodes (130U), the memory gate electrodes (130M), and the lower gate electrodes (130L) and into the insulating layer (192) in the second direction, wherein ones of the second contact plugs (MC2) extend to different lengths from one another in the second direction and are electrically connected to the lower gate electrodes (130L) and/or the memory gate electrodes (130M), respectively, in the second region;
a side-surface insulating structure (160, 170) that extends around a side surface of each of the second contact plugs (MC2) in the second region; and
an upper side-surface insulating layer (175) that extends around a side surface of each of the first contact plugs (MC1) in the third region.

2. The semiconductor device of claim 1, wherein a lower end of the upper side-surface insulating layer (175) is coplanar with an upper surface of the stack structure.

3. The semiconductor device of claim 1 or claim 2, wherein upper surfaces of the first contact plugs (MC1) are coplanar with upper surfaces of the second contact plugs (MC1).

4. The semiconductor device of any preceding claim, wherein the first contact plugs (MC1) and the second contact plugs (MC2) include a same material.

5. The semiconductor device of any preceding claim, wherein the side-surface insulating structure (160) includes:
a first side-surface insulating layer (160) between the stack structure and the side surface of the each of the second contact plugs (MC2); and
a second side-surface insulating layer (170) between the first side-surface insulating layer (160) and the side surface of the each of the second contact plugs (MC2),
wherein a lower end of the first side-surface insulating layer (160) and a lower end of the second side-surface insulating layer (170) are coplanar with each other.

6. The semiconductor device of claim 5, wherein an upper end of the second side-surface insulating layer (170) is farther from the upper surface of the conductive layer (101) in the second direction than an upper end of the first side-surface insulating layer (160).

7. The semiconductor device of claim 5 or claim 6, wherein an upper end of the second side-surface insulating layer (170) and upper surfaces of the second contact plugs (MC2) are coplanar with each other.

8. The semiconductor device of any of claims 5-7, wherein the second side-surface insulating layer (170) and the upper side-surface insulating layer (175) include a same material.

9. The semiconductor device of any of claims 5-8, wherein the second side-surface insulating layer (170) and the first side-surface insulating layer (160) include a same material, and
wherein a density of the second side-surface insulating layer (170) and a density of the first side-surface insulating layer (160) are different from each other.

10. The semiconductor device of any preceding claim, wherein the insulating layer (192) and the upper side-surface insulating layer (175) include a same material, and
wherein a density of the upper side-surface insulating layer (175) is less than a density of the insulating layer (192).

11. The semiconductor device of any preceding claim, wherein the upper side-surface insulating layer (175) includes an inner side surface and an outer side surface between an upper end and a lower end of the upper side-surface insulating layer (175), and
wherein a slope of the outer side surface and a slope of the inner side surface are different from each other.

12. The semiconductor device of claim 11, wherein the upper end of the upper side-surface insulating layer (175) is closer to the upper surface of the conductive layer (101) in the second direction than upper surfaces of the first contact plugs (MC1), and
wherein the lower end of the upper side-surface insulating layer (175) is farther from the upper surface of the conductive layer (101) in the second direction than lower surfaces of the first contact plugs (MC1).

13. The semiconductor device of any preceding claim, further comprising:
first studs (180a) on respective upper surfaces of the first contact plugs (MC1); and
second studs (180b) on respective upper surfaces of the second contact plugs (MC2),
wherein upper surfaces of the first studs (180a) are coplanar with upper surfaces of the second studs (180b), and
wherein lower surfaces of the first studs (180a) are coplanar with lower surfaces of the second studs (180b).

14. The semiconductor device of claim 13, wherein a diameter of at least one of the respective upper surfaces of the first studs (180a) is equal to a diameter of at least one of the respective upper surfaces of the second studs (180b), and
wherein the first studs (180a) and the second studs (180b) include a same material.

15. A data storage system, comprising:
a semiconductor storage device that includes a first semiconductor structure (S2) that includes circuit devices (220), a second semiconductor structure (S1) comprising the semiconductor device of any one of claims 1 to 14, and an input/output pad that is electrically connected to the circuit devices; and
a controller that is electrically connected to the semiconductor storage device through the input/output pad, wherein the controller is configured to control the semiconductor storage device.
